# EUROPÄISCHE PATENTSCHRIFT

(11) **EP 4 018 472 B1**
(45) Veröffentlichungstag und Bekanntmachung des Hinweises auf die Patenterteilung: **13.08.2025**
(21) Anmeldenummer: 19758964.1
(22) Anmeldetag: 23.08.2019
(51) Int. Cl.: H01L 21/67, H01L 21/68, H01L 21/18

(54) **VERFAHREN UND VORRICHTUNG ZUM AUSRICHTEN VON SUBSTRATEN**
METHOD AND APPARATUS FOR ALIGNMENT OF SUBSTRATES
MÉTHODE ET APPAREIL POUR ALIGNEMENT DE SUBSTRATS

(43) Veröffentlichungstag der Anmeldung: 29.06.2022
(73) Patentinhaber: EV Group E. Thallner GmbH, 4782 St. Florian am Inn (AT)
(72) Erfinder: WAGENLEITNER, Thomas, 4971 Aurolzmünster (AT); ROHRINGER, Harald, 4911 Tumeltsham (AT)
(74) Vertreter: Schneider, Sascha
(86) Internationale Anmeldenummer: PCT/EP2019/072589
(87) Internationale Veröffentlichungsnummer: WO 2021/037328

(56) Entgegenhaltungen:
- JP-A- 2005 251 972
- JP-A- 2014 013 916
- US-A1- 2007 252 994
- US-A1- 2010 139 836
- US-A1- 2012 255 365
- US-A1- 2016 155 721
- US-A1- 2019 198 371

## Beschreibung

Im Stand der Technik existieren unzählige Ausrichtungsanlagen. Sehr viele der Ausrichtungsanlagen beruhen darauf, eine Messvorrichtung zur Vermessung der Ausrichtungsmarken zwischen den beiden Substraten einzufügen. Der Nachteil derartiger Ausrichtungsanlagen besteht darin, dass die zwischen den Substraten eingeführte Messvorrichtung die Substratoberfläche des unteren Substrats kontaminieren kann. Ein weiterer, noch größerer Nachteil besteht darin, dass die Messvorrichtung eine gewisse Höhe besitzt. Die beiden Substrate müssen daher mindestens um diese Höhe voneinander entfernt sein. Nachdem die Messvorrichtung die beiden Substratoberflächen vermessen hat und entfernt wurde, müssen die Substrate immer noch aneinander angenähert werden und zwar entlang des gesamten Abstands zwischen den Substraten. Während dieser Annäherung kann bereits eine erneute Verschiebung in lateraler Richtung zwischen den Substraten erfolgen und damit die vorher vermessene und eingestellte laterale Ausrichtung der Substrate zueinander wieder zunichtemachen.

Eine Weiterentwicklung im Stand der Technik stellen Ausrichtungsanlagen dar, bei denen die aufeinander zugewandten Substratoberflächen der Substrate nur einige wenige Millimeter, vorzugsweise sogar nur einige wenige Mikrometer, am allerbevorzugtesten sogar nur wenige Nanometer, voneinander entfernt sind. Dieser geringe Abstand erlaubt kein Einfügen einer Messvorrichtung. Um die Substrate dennoch anhand ihrer Ausrichtungsmarken zueinander ausrichten zu können müssen die Substrate zueinander lateral verschoben werden. Die Ausrichtungsmarken werden dann von mehreren Optiken im lateral verschobenen Zustand vermessen und die Positionen der Substrathalter die eingenommen werden müssen um die Ausrichtungsmarken exakt zur Deckung zu bringen werden berechnet. Derartige Ausrichtungsanlagen werden in den Druckschriften US6214692B1, WO2014202106A1, WO2015082020A1 und WO2011042093A1 ausführlich behandelt. Voraussetzung für derartige Ausrichtungsanlagen sind Substrathalter, die sehr präzise positioniert werden können. Des Weiteren muss die Position der Substrathalter zu jedem Zeitpunkt auch exakt vermessen werden können.

Weitere Informationen zum Stand der Technik werden in den Dokumenten US2019/0198371-A1, US2010/0139836-A1, JP2005-251972A und JP2014-13916A offenbart.

Das größte Problem im Stand der Technik besteht darin, dass die Substrate über die Substrathalter in Position gebracht werden müssen und diese Positionierung nur so genau erfolgen kann wie die Substrathalter angesteuert bzw. deren exakte Position vermessen werden kann. Da der laterale Weg den die Substrathalter zurücklegen mehrere Millimeter bis Zentimeter beträgt, ist eine, insbesondere reproduzierbare, Positionierung im Mikrometer bzw. Nanometerbereich sehr schwer zu erreichen. Man benötigt sehr exakte Positionsvermessungssysteme, insbesondere Interferometer, die entsprechen kostspielig, wartungsintensiv und fehleranfällig sein können.

Es ist daher Aufgabe der vorliegenden Erfindung ein Verfahren und eine Vorrichtung aufzuzeigen, welche die im Stand der Technik aufgeführten Nachteile zumindest zum Teil beseitigen, insbesondere vollständig beseitigen. Insbesondere ist es eine Aufgabe der Erfindung ein verbessertes Verfahren und eine Vorrichtung aufzuzeigen, um zwei Substrate zueinander, insbesondere exakt, auszurichten.

Die vorliegende Aufgabe wird mit den Merkmalen der nebengeordneten Ansprüche gelöst. Vorteilhafte Weiterbildungen der Erfindung sind in den Unteransprüchen angegeben. In den Rahmen der Erfindung fallen auch sämtliche Kombinationen aus zumindest zwei in der Beschreibung, in den Ansprüchen und/oder den Zeichnungen angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Demnach betrifft die Erfindung eine Vorrichtung zum Ausrichten von Substraten, umfassend:
- einen ersten Substrathalter zur Aufnahme eines ersten Substrates, wobei das erste Substrat mindestens zwei Ausrichtungsmarken aufweist,
- einen zweiten Substrathalter zur Aufnahme eines zweiten Substrates, wobei das zweite Substrat mindestens zwei weitere Ausrichtungsmarken aufweist,
- mindestens eine Ausrichtungsoptik zur Erfassung der Ausrichtungsmarken,
   wobei,
- die Vorrichtung weiterhin aufweist:
- mindestens eine Positionsoptik zur Erfassung von Positionsmarken,
wobei die Ausrichtungsmarken des ersten Substrates und die weiteren Ausrichtungsmarken des zweiten Substrates in Abhängigkeit der Positionsmarken zueinander ausrichtbar sind.

Bei dem Ausrichten der Substrate beziehungsweise der Ausrichtungsmarken der Substrate können die Positionsmarken für eine exakte Ausrichtung verwendet werden. Dabei kann die Position der Ausrichtungsmarken relativ zu den Positionsmarken bestimmt werden und eine Ansteuerung der Substrathalter vorteilhaft über die als Referenz dienenden Positionsmarken durchgeführt werden. Dadurch ist vorteilhaft eine Ausrichtung über die Ausrichtungsmarken nicht notwendig, so dass die Ausrichtung auch genau ausführbar ist, wenn die Ausrichtungsmarken für die Ausrichtungsoptiken unzugänglich sind, insbesondere wenn die Substrate und damit die Ausrichtungsmarken sehr nah zueinander angeordnet sind. Insbesondere kann die Position beim Ausrichten der Substrate, insbesondere von Ausrichtungsmarken die auf den Substraten angeordnet sind, bestimmen zu können, wenn die Substrate übereinander angeordnet sind und die zueinander zeigenden Substratoberflächen nur wenige Millimeter, insbesondere nur wenige Nanometer, voneinander entfernt sind. Weiterhin vorteilhaft kann eine übliche Ausrichtungsanlage um die erfindungsgemäßen Aspekte einfach und günstig erweitert werden. Weiterhin vorteilhaft kann der laterale Weg, um den die Substrate in dem Ausrichtungsprozess bewegt werden, möglichst geringgehalten werden.

Weiterhin betrifft die Erfindung ein Verfahren zum Ausrichten von zwei Substraten, insbesondere mit der Vorrichtung zum Ausrichten von Substraten, mit zumindest den folgenden Schritten, insbesondere mit dem folgenden Ablauf:
i) Fixieren zweier Substrate auf jeweils einem Substrathalter,
ii) Erfassen von Ausrichtungsmarken auf den Substraten,
iii) Erfassen von Positionsmarken,
iv) Ausrichten der Ausrichtungsmarken der Substrate zueinander in Abhängigkeit der Positionsmarken.

Bei dem Ausrichten wird nach der Fixierung der Substrate zunächst die Position der Ausrichtungsmarken erfasst. Dabei oder anschließend wird die Position der Ausrichtungsmarken mit der Position der Positionsmarken in Verbindung gesetzt beziehungsweise in Relation gesetzt. Vorzugsweise findet bei der Festlegung der Referenz keine Relativbewegung der Substrate statt. Vorteilhaft kann dann eine Ausrichtung der Substrate beziehungsweise der auf den Substraten angeordneten Ausrichtungsmarken über die Positionsmarken erfolgen.

In einer bevorzugten Ausführungsform der Erfindung ist vorgesehen, dass die Ausrichtungsmarken der Substrate über die Positionsmarken zueinander ausrichtbar sind, wenn eine oder mehrere der mindestens zwei Ausrichtungsmarken des ersten Substrates durch das zweite Substrat für die mindestens eine Ausrichtungsoptik verdeckt wird und/oder wenn eine oder mehrere der mindestens zwei weiteren Ausrichtungsmarken des zweiten Substrates durch das erste Substrat für die mindestens eine Ausrichtungsoptik verdeckt wird. Dadurch kann vorteilhaft mittels der, als Referenz dienenden, Positionsmarken die Ausrichtung auch im verdeckten Zustand erfolgen. Insbesondere ist dann ein Bewegen der Substrate beim Ausrichten, um die Position der Ausrichtungsmarken zu erfassen, nicht mehr notwendig. Mithin können Relativbewegungen über große Distanzen vermieden werden. Die Ausrichtung kann so besonders genau ausgeführt werden.

In einer anderen bevorzugten Ausführungsform der Erfindung ist vorgesehen, dass ein Positionsmarkenfeld durch die, insbesondere regelmäßig angeordneten, Positionsmarken ausgebildet ist, wobei insbesondere die Lage von unterschiedlichen Positionsmarken, insbesondere in dem durch die Positionsmarken ausgebildeten Positionsmarkenfeld, zueinander bekannt ist.

Die Positionsmarken sind vorzugsweise regelmäßig in dem Positionsmarkenfeld angeordnet. Die Positionsmarken eines Positionsmarkenfeldes sind vorzugsweise in einer Ebene nebeneinander angeordnet. Denkbar ist auch, dass mehrere Positionsmarkenfelder mit jeweils mehreren Positionsmarken an der Vorrichtung ausgebildet sind. Dabei ist insbesondere die Position der einzelnen Positionsmarken beziehungsweise die Lage der einzelnen Positionsmarken im Feld bekannt. Dadurch kann vorteilhaft mit jeder Positionsmarke die Lage einer anderen Positionsmarke erfasst werden. Weiterhin vorteilhaft ist es nicht notwendig, dass die Positionsoptik relativ zum Positionsmarkenfeld bewegt werden muss. Vielmehr kann die Positionsoptik auch an der gewünschten Position verbleiben und durch ein Bewegen des Substrathalters die Ausrichtung erfolgen. Weiterhin kann die Referenz der Ausrichtungsmarke vorteilhaft zu verschiedenen Positionsmarken gesetzt werden beziehungsweise in Korrelation gesetzt werden. Insbesondere kann die Position berechnet werden, da die Lage der jeweils durch die Positionsoptik erfassten Positionsmarke zu den anderen Positionsmarken bekannt ist.

Die Länge des Positionsmarkenfeld ist größer als 0.1 mm, vorzugsweise größer als 1 mm, noch bevorzugter größer als 10 mm, am bevorzugtesten größer als 100 mm, am allerbevorzugtesten größer als 300 mm.

Die Breite des Positionsmarkenfeld ist größer als 0.1 mm, vorzugsweise größer als 1 mm, noch bevorzugter größer als 10 mm, am bevorzugtesten größer als 100 mm, am allerbevorzugtesten größer als 300 mm.

Weiterhin ist vorteilhaft vorgesehen relativ große Positionsmarkenfelder zu erzeugen, um einen sehr großen Verfahrweg der Substrathalter abdecken zu können. Durch die Verwendung von großen Positionsmarkenfeldern ist es somit vorteilhaft möglich, zu jedem Zeitpunkt eine exakte Positionsbestimmung des Substrathalters durchführen zu können.

In einer anderen bevorzugten Ausführungsform der Erfindung ist vorgesehen, dass die Positionsmarken durch eine Vielzahl von, insbesondere unregelmäßig angeordneten, Feinpositionierungselementen ausgebildet sind. Dabei ist insbesondere die Anordnung der Feinpositionierungselemente bekannt. Dadurch kann vorteilhaft eine Feinpositionierung bei der Ausrichtung über die Feinpositionierungselemente erfolgen. Die einzelnen Feinpositionierungselemente können ebenfalls von der Positionsoptik erfasst werden. Dabei ist insbesondere vorgesehen, dass die Feinpositionierung über die Feinpositionierungselemente einer Positionsmarke erfolgt. Insbesondere kann vorgesehen sein, dass eine Positionsmarke ein bestimmtes Feinpositionierungselement aufweist, welches als Koordinatenursprung angesehen und erfasst werden kann. Dadurch kann vorteilhaft der Abstand beziehungsweise die Lage jedes einzelne Feinpositionierungselement relativ zu dem bestimmten Feinpositionierungselement der Positionsmarke bestimmt werden. Vorteilhaft genau ist das Festlegen bei dem in Korrelation setzten mit der Position der Ausrichtungsmarke möglich. Weiterhin vorteilhaft kann auf diese Weise die Ausrichtung der Ausrichtungsmarken beziehungsweise der Substrate zueinander durchgeführt werden.

In einer anderen bevorzugten Ausführungsform der Erfindung ist vorgesehen, dass jede Positionsmarke unterschiedlich ausgebildet ist, wobei insbesondere die Positionsmarken einen bestimmten, insbesondere durch die Positionsoptik erfassbaren, Informationsgehalt aufweist. Mittels der unterschiedlich ausgebildeten Positionsmarken kann die jeweilige Positionsmarke erkannt und einer Lage im Positionsmarkenfeld zugeordnet werden. Vorzugsweise wird dies durch die unterschiedlich angeordneten Feinpositionierungselemente ermöglicht. Insbesondere kann durch die Anordnung der Feinpositionierungselemente und damit die Positionsmarke selbst ein Informationsgehalt aufweisen. Insbesondere ist der Informationsgehalt bekannt beziehungsweise in einem Speicher hinterlegt. Nach dem Erfassen der Positionsmarke kann ist damit insbesondere die exakte Lage der jeweiligen Positionsmarke im Markenfeld bekannt. Vorzugsweise kann, wenn bereits ein in Referenzsetzen zu einer Ausrichtungsmarke der erfassten Positionsmarke erfolgt ist, auf dieser Grundlage bereits die Ausrichtung der Substrate zueinander durchgeführt werden.

In einer anderen bevorzugten Ausführungsform der Erfindung ist vorgesehen, dass die Positionsmarken eine oder mehrere der folgenden Ausprägungen aufweist:
- QR Code
- Strichcode
- Geometrische, insbesondere dreidimensionale, Figur,
- Zeichenfolge, insbesondere Buchstabenfolge und/oder Zahlenfolge, vorzugsweise Binärcode,
- Bild.

Durch die verschiedenen Ausprägungen kann ein unterschiedlich hoher Informationsgehalt in den Positionsmarken hinterlegt sein. Bevorzugt ist die Verwendung eines QR-Codes vorgesehen. Vorteilhaft kann dann bei verschiedenen Prozessparametern eine genaue Ausrichtung der Substrate zueinander erfolgen.

In einer anderen bevorzugten Ausführungsform der Erfindung ist vorgesehen, dass mindestens ein Substrathalter und/oder die mindestens eine Positionsoptik in mindestens zwei Richtungen, insbesondere in x-Richtung und y-Richtung, bewegbar ist. Um die Korrelation zwischen Ausrichtungsmarken und Positionsmarken herzustellen, ist es insbesondere notwendig, dass mindestens ein Substrathalter und/oder die mindestens eine Positionsoptik relativ zu der jeweiligen Substratoberfläche und/oder zu den Positionsmarken bewegt werden. Dazu können insbesondere auch Öffnungen im Substrathalter vorgesehen sein, welche den fixierten und/oder bewegbaren Optiken die Erfassung der jeweiligen Marken durch den Substrathalter ermöglichen. Auf diese Weise kann vorteilhaft die laterale Bewegung der Substrate zueinander bei der Ausrichtung möglichst geringgehalten werden.

In einer anderen bevorzugten Ausführungsform der Erfindung ist vorgesehen, dass die Positionsmarken seitlich neben mindestens einem der Substrate angeordnet sind, wodurch insbesondere die Ausrichtungsmarken der Substrate zueinander ausrichtbar sind, wenn die Ausrichtungsmarken des einen Substrates durch das andere Substrat für die mindestens eine Ausrichtungsoptik verdeckt sind. Insbesondere wenn die Substrate übereinander angeordnet sind, ungefähr in axialer Richtung fluchten und die zu verbondenden Substratoberflächen einander sehr nah angeordnet sind, werden die auf den Substraten angeordneten Ausrichtungsmarken von dem jeweils anderen Substrat verdeckt. Die Positionsmarken sind vorzugsweise außerhalb vom Substrat auf der durch die jeweilige Substratoberfläche aufgespannten Ebene angeordnet und werden mithin nicht verdeckt. Dadurch kann vorteilhaft eine Ausrichtung über die Positionsmarken stattfinden, auch wenn die Substrate sehr nah aneinander angeordnet sind.

In einer anderen bevorzugten Ausführungsform der Erfindung ist vorgesehen, dass die Positionsmarken auf mindestens einem der Substrathalter angeordnet sind. Vorzugsweise sind die Positionsmarken an dem jeweiligen Substrathalter angeordnet. Dadurch kann vorteilhaft die Position der Positionsmarken direkt mit der Bewegung des jeweiligen Substrathalters in Verbindung gebracht werden. Insbesondere ist die durch die Positionsoptik erfasste Bewegung beziehungsweise Lage der Positionsmarken direkt mit der Bewegung des jeweiligen Substrathalters gekoppelt. Dadurch ist eine Ausrichtung vorteilhaft genau durchführbar.

In einer anderen bevorzugten Ausführungsform der Erfindung ist vorgesehen, dass die Positionsmarken auf mindestens einer Substrathalteroberfläche angeordnet sind. Bevorzugt sind die Positionsmarken auf der Substrathalteroberfläche angeordnet. Auf diese Weise ist die Sicht auf die Positionsmarken für die Positionsoptiken nicht durch andere am Substrathalter angeordneter Teile verhindert.

In einer anderen bevorzugten Ausführungsform der Erfindung ist vorgesehen, dass die Positionsmarken auf der gleichen Höhe mit einer Substratoberfläche mindestens eines der Substrate angeordnet sind. Die vorzugsweise auf der Substratoberfläche angeordneten Ausrichtungsmarken liegen bevorzugt auf der gleichen Höhe wie die Positionsmarken. Dadurch kann vorteilhaft ein jeweils eingestellter Fokuspunkt der Positionsoptik und der Ausrichtungsoptik gleich eingestellt werden. Insbesondere wenn die Positionsoptik und die Ausrichtungsoptik die gleiche Fokussierungseinheit verwenden. Zusätzlich liegen dann die Ausrichtungsmarken und die als Referenz gesetzten Positionsmarken auf der gleichen axialen Höhe. Dadurch braucht der Substrathalter insbesondere nur noch in x-Richtung und/oder y-Richtung zum Ausrichten bewegt werden.

In einer anderen bevorzugten Ausführungsform der Erfindung ist vorgesehen, dass die Positionen der Ausrichtungsmarken der Substrate, insbesondere kontinuierlich, durch die mindestens eine Positionsoptik bei dem Ausrichten der Ausrichtungsmarken der Substrate zueinander erfassbar ist. Vorzugsweise kann zu jedem Zeitpunkt nach in Verbindungsetzten von Ausrichtungsmarken und Positionsmarken durch die Positionsoptik die aktuelle Lage der Substrate bestimmt werden. Vorteilhaft können so auch andere zusätzliche Verfahrensschritte auf die genaue Lageinformation der Substrate zurückgreifen. Ein kontinuierliches Überprüfen der Lage bei dem Bewegen der Substrathalter und/oder der Positionsoptik kann zusätzlich vorteilhaft Abweichungen von einer bestimmten beziehungsweise gewünschten Lage registrieren. Auf diese Weise ist eine Fehlerfrüherkennung während der Ausrichtung möglich.

Die Erfindung beschreibt ein Verfahren und eine Vorrichtung zum Ausrichten von Substraten. Die Ausrichtungsmarken an denen die beiden Substrate zueinander ausgerichtet werden befinden sich an den zueinander zugewandten Substratoberflächen. Die Ausrichtungsmarken eines jeden Substrats werden daher, insbesondere spätestens während des Bondens, durch das jeweils gegenüberliegende Substrat verdeckt. Die Idee beschreibt die Verwendung mindestens eines Positionsmarkenfeldes, insbesondere eines QR-Feldes, mit dessen Hilfe die Positioniergenauigkeit der Substrathalter und damit der darauf fixierten Substrate erhöht werden kann. Durch diesen Aspekt ist es möglich die Position der Ausrichtungsmarken zueinander exakt zu berechnen, ohne die Ausrichtungsmarken beobachten zu müssen. Die Idee wird ausführlich für drei Typen von Ausrichtungsanlagen beschrieben.

Der Kern der Erfindung besteht insbesondere darin, eine Vorrichtung und ein Verfahren aufzuzeigen, mit deren Hilfe eine Ausrichtung zweier Substrate anhand ihrer Ausrichtungsmarken über ein System von Optiken erfolgt. Bei den Optiken handelt es sich um die aus dem Stand der Technik bekannten Ausrichtungsoptiken, mit deren Hilfe die Ausrichtungsmarken verbessert werden. Erfindungsgemäß wird mindestens eine insbesondere zusätzliche Positionsoptik verwendet, mit deren Hilfe mindestens ein Positionsmarkenfeld, insbesondere ein QR Markenfeld, optisch vermessen werden kann. Das Positionsmarkenfeld wird als Referenzfeld verwendet um die exakte Position der Substrathalter und damit der Substrate bestimmen zu können.

Mit dem Verfahren und der entsprechenden Vorrichtung ist es zwar immer noch notwendig eine laterale Verschiebung der Substrathalter durchzuführen, allerdings wird die aktuelle Ist-Position eines Substrathalters durch eine Menge von Positionsmarken, insbesondere QR Marken, des Positionsmarkendfeldes zumindest zu dem Zeitpunkt erfasst, zu dem die Ausrichtungsmarken nicht mehr durch die Ausrichtungsoptiken sichtbar beziehungsweise erfassbar sind. Die Positionsmarken sind durch Soft- und/oder Hard- und/oder Firmware lesbar und interpretierbar. Interpretierbar bedeutet, dass in den Marken selbst eine Grobpositionsangabe codiert wird. Die Feinpositionierung kann dann über die Pixelposition durchgeführt werden.

Mit Hilfe der Vorrichtung und des entsprechenden Verfahrens ist es möglich, die exakte Position der Ausrichtungsmarken nicht über die Vermessung der Ausrichtungsmarken selbst, sondern über die Vermessung der Positionsmarken, kontinuierlich, insbesondere in dem Zustand, in dem die Ausrichtungsmarken von dem jeweiligen gegenüberliegend Substrat verdeckt werden, nachzuverfolgen bzw. korrekt zu berechnen.

Die Idee ist insbesondere eine Erweiterung, vorzugsweise ein Ersatz, für teurere, fehleranfälligere und wartungsintensivere Positionsmesssysteme, insbesondere Interferometer.

Ein weiterer entscheidender Vorteil besteht darin, dass die Idee ohne weiteres auf bestehende Anlagen angewandt werden kann und diese erweitern kann.

Eine völlige Neuentwicklung einer Ausrichtungsanlage ist daher nicht zwangsläufig notwendig.

Der Idee liegen beispielsweise die Ausrichtungsanlagen aus den Druckschriften US6214692B1, WO2014202106A1, WO2015082020A1 und WO2011042093A1 zugrunde. Auf die Beschreibung dieser Ausrichtungsanlagen wird daher nur oberflächlich eingegangen, allerdings wird die Idee ausführlich an Hand dreier Verfahren, die den Ausrichtungsanlagen zuordenbar sind, beschrieben um die Flexibilität der Idee zu demonstrieren.

Entscheiden ist, dass alle Ausrichtungsanlagen, insbesondere jene der oben genannten Druckschriften, um die erfindungsgemäßen Aspekte erweitert werden können. Die Idee besteht also vor allem darin, ein Positionsmarkenfeld, insbesondere ein QR Markenfeld, und mindestens eine zusätzliche Positionsmarkenoptik zu verwenden um zu einem vorgegebenen Zeitpunkt die Positionsmarken des Positionsmarkenfeldes zu vermessen, während gleichzeitig die Position mindestens einer Ausrichtungsmarke mit einer Ausrichtungsoptik vermessen wird. Da die mindestens eine Positionsmarkenoptik relativ zu den Ausrichtungsoptiken nicht mehr bewegt wird, ist die Position einer Ausrichtungsmarke, auch wenn diese verdeckt wird, durch die Vermessung einer Positionsmarke des Positionsmarkenfeldes immer berechenbar und damit bekannt.

### Marken

Um die Idee bestmöglich zu beschreiben wird zwischen Ausrichtungsmarken und Positionsmarken unterschieden.

### Ausrichtungsmarken

Unter Ausrichtungsmarken versteht man jene Marken, die auf den Substraten aufgebracht beziehungsweise erzeugt wurden und die im Prozess zur Deckung gebracht werden müssen, insbesondere zueinander exakt ausgerichtet werden müssen. Ausrichtungsmarken dienen der exakten Positionierung zweier Substrate zueinander. Die Ausrichtung zweier Substrate durch ihre Ausrichtungsmarken ist umso effektiver, je geringer der Abstand zwischen den Ausrichtungsmarken der beiden Substrate ist. Deshalb ist eine sogenannte back-to-back Ausrichtung, bei der sich die Ausrichtungsmarken an den Rückseiten der Substrate befinden weniger effektiv als eine sogenannte face-to-face Ausrichtung, bei der die Ausrichtungsmarken sich an den zu verbindenden, insbesondere zueinander zeigenden Substratoberflächen befinden. Nachteilig an der face-to-face Ausrichtung ist allerdings, dass die Ausrichtungsmarken an einer ersten Substratoberfläche eines ersten Substrats durch das jeweils gegenüberliegende, zweite Substrat verdeckt werden, sofern sich die Ausrichtungsmarken in unmittelbare Nähe zueinander befinden. Werden Vermessungsmethoden gewählt, bei denen das Substrat nicht durch Transmission vermessen werden kann, gibt es keine Möglichkeit die Ausrichtungsmarken in diesem Zustand zu detektieren und daher auch keine Möglichkeit die Substrate korrekt zueinander auszurichten. Obwohl eine Infrarotvermessung bei einigen Substraten grundsätzlich eine Möglichkeit darstellen würde die Substrate zueinander auszurichten, ist diese Messmethode sehr oft durch eine metallische Beschichtung der Substrate dennoch nicht einsetzbar. Metalle sind grundsätzlich infrarotintransparent. Es bleiben also nur mehr Möglichkeiten übrig, bei denen die Ausrichtungsmarken in einem Zustand vermessen werden, in dem das jeweils gegenüberliegende Substrat verschoben wird um nach der Vermessung der Ausrichtungsmarken mittels eines hochgenauen Positionierprozesses die Substrathalter und damit die Substrate zueinander auszurichten.

Auf die genaue Form der Ausrichtungsmarken muss nicht genauer eingegangen werden, da es in der Industrie unzählige Arten von Ausrichtungsmarken gibt. In den Figuren dieser Druckschrift werden Ausrichtungsmarken vereinfacht als schwarze Kreuze dargestellt.

### Positionsmarken

Unter Positionsmarken versteht man jene Marken, die durch zusätzliche Optiken, die Positionsoptiken, insbesondere kontinuierlich verfolgt, beobachtet und ausgewertet werden, um die exakte Position der Substrathalter und damit der Substrate bestimmen zu können auch während die Ausrichtungsmarken auf einem Substrat durch das jeweils gegenüberliegende Substrat verdeckt und damit optisch nicht mehr zugänglich sind.

Die Positionsmarken befinden sich vorzugsweise auf dem Substrathalter.

Jede Positionsmarke wird vorzugsweise so hergestellt, dass aus ihr eine, insbesondere grobe, Position ausgelesen werden kann. Als Positionsmarken eignen sich insbesondere
- QR Codes
- Barcodes,
- Text
- Symbole
- Etc.

In einer QR Positionsmarke wird insbesondere die Grobposition direkt im QR Code verschlüsselt. Bei den in den Figuren der Druckschrift dargestellten Positionsmarken handelt es sich um QR Codes. Die QR Codes können zum besseren Verständnis der Druckschrift mit einem handelsüblichen QR Scanner, beispielsweise einer Kamera eines Smartphones, ausgelesen werden. Dadurch wird dem Fachmann der diese Druckschrift liest, das Verständnis für die Grobpositionierung erleichtert.

Eine Barcode Positionsmarke könnte die Grobposition als Integer verschlüsselt speichern. Denkbar wäre beispielsweise, dass der Integer 101012 für die Grobposition (101,012) steht. Man einigt sich darauf, dass die ersten n von N Ziffern der x-Koordinate entsprechen und die letzten N-n Ziffern der y-Koordinate.

Wird ein Text als Positionsmarke verwendet, kann die Grobposition direkt als Text dargestellt werden. Denkbar wäre beispielsweise die Verwendung des Textfragments "101,12" um die Grobposition (101,12) festzulegen.

Bei den symbolischen Positionsmarken benötigt man insbesondere eine Zuordnungstabelle. Ein spezielles Symbol wird einer Grobposition (x, y) zugeordnet. Denkbar wäre auch, dass eine symbolische Positionsmarke aus zwei Teilsymbolen besteht, von denen jedes Teilsymbol einer Koordinate entspricht, die in einer entsprechenden Tabelle festgelegt wurde.

Des Weiteren verfügt jede Positionsmarke vorzugsweise über Feinpositionierelemente, durch die der Positionsmarke eine eigene Feinposition zugeordnet werden kann. Die in der Positionsmarke verschlüsselte Position reicht im Allgemeinen nicht aus, um eine Feinpositionierung durchzuführen.

Bei den Feinpositionierelementen kann es sich beispielsweise um einen Rahmen handeln, der die Positionsmarke umgibt. Denkbar wären beispielsweise Rechtecke, insbesondere Quadrate. Denkbar wären auch symmetrische Achtecke oder Kreise. Die Feinpositionierelementen können detektiert und durch Hard- und/oder Soft- und/oder Firmware so ausgewertet werden, dass man durch sie einen lokalen Nullpunkt für die Positionsmarke erhält, der nur durch die Pixelauflösung des Detektors begrenzt ist. Über die relative Verschiebung dieses Nullpunkts relativ zur optischen Achse der Positionsoptik wird dann die Feinjustierung ermöglicht, mithin insbesondere eine exakte Ausrichtung der Substrate möglich beziehungsweise eine Berechnung zur Bestimmung der exakten Position der Ausrichtungsmarken und damit der exakten Position der Substrate, welche insbesondere auf den Substrathaltern fixiert sind. Denkbar wäre auch, dass einzelne Merkmale der Positionsmarke, beispielsweise Ecken oder Kanten, selbst als Feinpositionierungselemente dienen.

### Positionsmarkenfeld

Die Positionsmarken sind insbesondere Teil eines Positionsmarkenfeldes. Die Positionsmarken sind in dem Positionsmarkenfeld insbesondere symmetrisch, insbesondere entlang eines Rasters, angeordnet. Die in den Positionsmarken codierten Positionen werden in Bezug zu einem Koordinatenursprung des Positionsmarkenfeldes angegeben.

Im Idealfall sollte das Positionsmarkenfeld auf einer Oberfläche eines Körpers gefertigt werden, der sich unter jeglicher Änderung eines physikalischen Parameters wie Druck und Temperatur nur sehr gering, vorzugsweise gar nicht, in seiner Form ändert. Der Körper auf dem ein Positionsmarkenfeld erzeugt wird sollte daher einen thermischen Ausdehnungskoeffiziententensor besitzen, dessen Koeffizienten möglichst klein sind. Vorzugsweise wird der Körper aus einem Material mit kubischem Kristallsystem gefertigt, da in diesem Fall die thermische Ausdehnung immer isotrop ist. In diesem Fall kann anstatt eines Ausdehnungskoeffiziententensors einfach ein thermischer Ausdehnungskoeffizient verwendet werden.

Der Körper sollte möglichst unempfindlich gegenüber Adsorbaten sein, insbesondere nicht oxidieren oder anderweitige chemische Reaktionen eingehen, die zu einer Schichtbildung führen. Insbesondere Nanometer dünne Oxidschichten können sehr ausgeprägte optische Eigenschaften aufweisen, die sich nachteilig auf die Auslesung der Positionsmarken auswirken kann. Dazu zählen beispielsweise Interferenzeffekt, Lichtbrechung etc.

In einer ganz besonders bevorzugten Ausführungsform befindet sich ein Positionsmarkenfeld ungefähr auf derselben Höhe wie die zu vermessenden Ausrichtungsmarken, insbesondere in einer Ebene die durch die Substratoberfläche aufgespannt wird, auf der die Ausrichtungsmarke angeordnet ist.

In einer weniger bevorzugten Ausführungsform befindet sich das Positionsmarkenfeld auf der, der Substrathalterfixieroberfläche gegenüberliegenden, Substrathalteraußenoberfläche und ist damit relativ weit von der Ebene, in der sich die Ausrichtungsmarken befinden entfernt.

Vorzugsweise existiert bezüglich des Positionsmarkenfeldes ein eigenes Koordinatensystem (Positionsmarkenfeldkoordinatensystem PMFKS) mit einer entsprechenden xP-Achse und einer dazu, vorzugsweise orthogonalen, yP-Achse. Bei einer der Positionsmarken handelt es sich vorzugsweise um eine Positionsmarke, die den Nullpunkt dieses PMFKS definiert.

Die Herstellung eines Positionsmarkenfeldes ist insbesondere immer mit Ungenauigkeiten verbunden. Jedes Produkt einer Fertigung kann immer nur mit der Genauigkeit und der Präzision der Fertigungsmaschine erzeugt werden. Es ist daher wichtig zu erwähnen, dass das Positionsmarkenfeld nicht über die gesamte Fläche isotop und/oder homogen gefertigt sein muss. Es reicht vollkommen aus, wenn die Positionsmarken, die mit den Ausrichtungsmarken assoziiert wurden, sich während des Ausrichtungsprozesses nicht verändern.

Vorzugsweise werden natürlich dennoch Positionsmarkenfelder angestrebt, die so genau und präzise wie möglich über die gesamte Positionsmarkenfeldfläche erzeugt werden.

### Optiken

Im weiteren Verlauf des Textes wird im Allgemeinen zwischen Ausrichtungsoptiken und Positionsoptiken unterschieden werden. Unter Ausrichtungsoptiken versteht man alle Optiken, welche die Ausrichtungsmarken erfassen, während man unter Positionsoptiken all jene Optiken versteht, welche die Positionsmarken vermessen. In speziellen Ausführungsformen werden Optiken verwendet, die gleichzeitig als Ausrichtungs- und Positionsoptiken verwendet werden. In diesen Fällen können die beiden Wörter synonym verwendet werden. Da der Aspekt der Idee allerdings auf einer Weiterentwicklung von Ausrichtungsanlagen beruht, die immer schon über Ausrichtungsoptiken verfügt haben, wird in einem solchen Fall das Wort Positionsoptik verwendet um eine Kontinuität und Konsistenz zu erzeugen.

Das Wort Optik wird im weiteren Verlauf des Textes als Synonym für ein, im Allgemeinen sehr kompliziertes, optisches System verwendet, d.h. für eine Menge optischer Elemente, mit deren Hilfe man ein Bild aufnehmen, insbesondere vergrößern kann. Die Optiken werden in den Bildern durch einfache Objektive symbolisiert. Hinter diesen Optiken können aber weitere optische Elemente wie Prismen, unterschiedliche Linsen, optische Filter, Spiegel etc. stehen. Die Optiken projizieren ein aufgenommenes Bild auf einen Chip, insbesondere einen CMOS Chip, welcher das Bild entsprechend weiterverarbeitet und insbesondere an eine Software überträgt.

Alle Optiken können im Allgemeinen translatorisch und/oder rotatorisch bewegt werden. Nach einer entsprechenden Kalibrierung der Optiken werden diese aber vorzugsweise nicht mehr bewegt. Eine Relativbewegung zwischen den Optiken und den Substrathaltern erfolgt dann nur noch durch die Bewegung der Substrathalter. Insbesondere sind auch die Fokusebenen bzw. Fokuspunkte und/oder der Schärfentiefebereich der Optiken einstellbar und werden vorzugsweise nach einer Kalibrierung auf eine Ebene nicht mehr verändert. Eine Ausnahme bilden vor allem die Optiken der später erwähnten und ausführlich beschriebenen Typ 3 Ausrichtungsanlage, welche in der Druckschrift WO2015082020A1 ausführlich erwähnt werden. In dieser Ausrichtungsanlage ist es notwendig, gerade die Optiken aktiv zu bewegen um das gewünschte Ausrichtungsergebnis zu erzielen.

### Positionsbestimmung

Das Verfahren erlaubt die exakte Positionierung eines Substrathalters, und damit eines Substrats, durch die Vermessung eines Positionsmarkenfeldes und die exakte Ansteuerung einer Position des Positionsmarkenfeldes. Um eine exakte Ansteuerung des Substrathalters zu ermöglichen, reicht es nicht, die Grobposition aus einer Positionsmarke des Positionsfeldes auszulesen, da diese nur eine Position angibt, die weit oberhalb der möglichen optischen Auflösungsgrenze liegt. Sobald eine Positionsmarke eines Positionsmarkenfeldes sich im Sichtbereich einer Positionsoptik befindet, kann ein Nullpunkt der Positionsmarke vermessen werden. Die Feinpositionierung des Substrathalters erfolgt dann durch die Abstandsvermessung zwischen dem Nullpunkt der Positionsoptik und dem Nullpunkt der Positionsmarke. Diese Feinpositionierung ist durch die Pixelauflösung des Detektors beschränkt, sofern die Pixelauflösung schlechter ist als die optische Auflösung, ansonsten ist die Auflösungsgrenze die optische Auflösung. Während einer Bewegung eines Substrathalters muss die Positionsoptik, im Zusammenspiel mit Hard- und/oder Soft- und/oder Firmware, also nur in der Lage sein, die Grobposition des Substrathalters durch Auslesen der durch ihren Sichtbereich fahrenden Positionsmarken auslesen zu können. Sobald dann eine gewünschte Grobposition erreich wurde, kann die Feinpositionierung über die Pixelvermessung stattfinden. In dieser Vermessungsstufe bewegt sich der Substrathalter insbesondere gar nicht oder so langsam, dass eine Vermessung aller notwendigen Positionsmarkenmerkmale möglich ist.

### Substrathalter

Ein Substrathalter verfügt insbesondere über eine Substrathalterfixieroberfläche und eine der Substrathalterfixieroberfläche gegenüberliegende Substrathalteraußenoberfläche.

Die Substrathalter verfügen über Fixierungen. Die Fixierungen dienen dem Festhalten der Substrate. Bei den Fixierungen kann es sich um
1. Mechanische Fixierungen, insbesondere
   1.1. Klemmen
2. Vakuumfixierungen, insbesondere mit
   2.1. einzeln ansteuerbare Vakuumbahnen
   2.2. miteinander verbundenen Vakuumbahnen
3. Elektrische Fixierungen, insbesondere
   3.1. Elektrostatische Fixierungen
4. Magnetische Fixierungen
5. Adhäsive Fixierungen, insbesondere
6. Gel-Pak Fixierungen
7. Fixierungen mit adhäsiven, insbesondere ansteuerbaren, Oberfläche handeln.

Die Fixierungen sind insbesondere elektronisch ansteuerbar. Die Vakuumfixierung ist die bevorzugte Fixierungsart. Die Vakuumfixierung besteht vorzugsweise aus mehreren Vakuumbahnen, die an der Oberfläche des Substrathalters austreten. Die Vakuumbahnen sind vorzugsweise einzeln ansteuerbar. In einer Anwendung sind einige Vakuumbahnen zu Vakuumbahnsegmenten vereint, die einzeln ansteuerbar, daher evakuiert oder geflutet werden können. Jedes Vakuumsegment ist insbesondere unabhängig von den anderen Vakuumsegmenten. Damit erhält man die Möglichkeit des Aufbaus einzeln ansteuerbarer Vakuumsegmente. Die Vakuumsegmente sind vorzugsweise ringförmig konstruiert. Dadurch wird eine gezielte, radialsymmetrische, insbesondere von Innen- nach Außen durchgeführte Fixierung und/oder Loslösung eines Substrats vom Substrathalter ermöglicht.

Der Substrathalter kann ein um die erfindungsgemäßen Eigenschaften erweiterter Substrathalter aus einer der Druckschriften WO2017162272A1, WO2018028801A1 und WO2019057286A1 sein. Insbesondere handelt es sich bei dem Substrathalter um einen Substrathalter mit einzeln ansteuerbaren Zonen und Fixierelementen gemäß der Ausführungsform der WO2017162272A1.

Das Positionsmarkenfeld kann sich auf der Substrathalterfixieroberfläche und/oder der Substrathalteraußenoberfläche befinden.

In einer besonders bevorzugten Ausführungsform befindet sich das Positionsmarkenfeld auf der Substrathalterfixieroberfläche. Diese Ausführungsform hat den Vorteil, dass der Schärfentiefebereich der Positionsoptiken auf derselben Höhe liegt wie der Schärfentiefebereich der Ausrichtungsoptiken, die sich insbesondere auf derselben Seite wie die Positionsoptiken befinden.

In einer noch bevorzugteren Ausführungsform liegt das Positionsmarkenfeld in derselben Höhe wie die zu bondende Substratoberfläche. Da das Substrat über eine gewisse Dicke verfügt muss das Positionsmarkenfeld entweder in Bezug zur Substrathalterfixeroberfläche erhöht sein, oder die Substrathalterfixieroberfläche muss im Substrathalter leicht zurückgesetzt werden. Das ist beispielsweise durch Fräsen mit einer Frästiefe, die ungefähr einer mittleren Substratdicke entspricht, zu erreichen.

In einer allgemeinen Ausführungsform besitzt ein Substrathalter innerhalb einer Vorrichtung 6 Freiheitsgrade, kann daher in x-, y- und z-Richtung verschoben, sowie um die x-, y- und z-Achsen rotiert werden. In einer speziellen Ausführungsform kann sich ein Substrathalter innerhalb einer Vorrichtung vorzugsweise nur um eine minimale Anzahl von Freiheitsgraden bewegen um den Fehlereinfluss durch die Vorrichtungen, welche die anderen Freiheitsgrade erlauben würden, zu minimieren.

Für einige genannte Ausrichtungsanlagen ist es notwendig, dass sich die Optiken sehr nahe an die Ausrichtungsmarken eines Substrats bewegen. Der Substrathalter kann daher über Löcher, Durchgänge, Bohrungen, Fräsungen, Ausnehmungen bzw. Ausbuchtungen, im weiteren Verlauf der Druckschrift mit dem Überbegriff Öffnungen bezeichnet, verfügen um den Optiken den ungehinderten Zugang, insbesondere auch einen Spielraum für laterale Verschiebungen zu ermöglichen. In den Öffnungen können insbesondere auch durchsichtige Materialien eingesetzt sein. Das gilt insbesondere für Ausrichtungsanlagen gemäß der Druckschrift WO2015082020A1.

### Vorrichtung

Bei den Vorrichtungen handelt es sich um Ausrichtungsanlagen. Die unterschiedlichen Arten von Ausrichtungsanlagen werden in vier Typen eingeteilt.

Der **Typ 1** ist eine Ausrichtungsanlage die auf dem Ausrichtungsprinzip der Druckschrift US6214692B1 beruht. Grundsätzlich geht es darum, mindestens einen der Substrathalter entlang einer Richtung zu verschieben die insbesondere Normal auf der Verbindungslinie zweier Ausrichtungsmarken und in der Substratoberfläche liegt. Durch diese Vorgehensweise werden die Substrathalter entlang relativ langer Wege verschoben. Die wechselseitige Verschiebung der Substrathalter in Verbindung mit den vier Ausrichtungsoptiken, von denen jeweils zwei gegenüberliegende Optiken auf einen Fokuspunkt in einer Fokusebene kalibriert werden, erlaubt die Ausrichtung zweier Substrate während sich diese in einem sehr geringen Abstand zueinander befinden.

Der **Typ 2** ist eine Ausrichtungsanlage die auf dem Ausrichtungsprinzip der Druckschrift WO2014202106A1 beruht. Grundsätzlich geht es darum, beide Substrathalter kreuzweise entlang einer Richtung zu verschieben, die parallel zur Verbindungslinie zweier Ausrichtungsmarken und in der Substratoberfläche liegt. Die Substrate werden also im Gegensatz zum Typ 1 "seitlich" verschoben. Durch die seitliche Verschiebung sind die Verschiebungen der Substrathalter viel kürzer als in der Typ 1 Ausrichtungsanlage. Die wechselseitige Verschiebung der Substrathalter in Verbindung mit den vier Ausrichtungsoptiken, von denen jeweils zwei gegenüberliegende Optiken auf einen Fokuspunkt in einer Fokusebene kalibriert werden, erlaubt die Ausrichtung zweier Substrate während sich diese in einem sehr geringen Abstand zueinander befinden. Daher werden vorzugsweise Substrathalter verwendet, bei denen sich die örtlich begrenzten Positionsmarkenfelder neben den Ausrichtungsmarken des zu ladenden Substrats befinden.

Der **Typ 3** ist eine Ausrichtungsanlage die auf dem Ausrichtungsprinzip der Druckschrift WO2015082020A1 beruht. Grundsätzlich geht es darum, die Optiken einer Seite, insbesondere der Unterseite, zu fixieren oder höchstens eine Bewegung in z-Richtung zuzulassen, während die Optiken an der gegenüberliegenden, insbesondere oberen, Seite in mehrere Richtungen, insbesondere mindestens in x- und y-Richtung frei beweglich sind. Des Weiteren ist in diesem Typ von Ausrichtungsanlage auch einer der, insbesondere der untere, Substrathalter nur in eine Richtung, insbesondere die z-Richtung beweglich. Im Gegensatz zu den Ausrichtungsanlagen von Typ 1 und 2 werden die Optiken hier nach dem Kalibrierprozess sehr wohl bewegt, während das untere Substrat zuerst fix bleibt und beim Bondprozess durch den unteren Substrathalter ausschließlich in z-Richtung bewegt wird.

Der **Typ 4** sind alle anderen Arten von Ausrichtungsanlagen, die auf optischen Prinzipien beruhen. Hier können grundsätzlich alle Arten von Positionsmarkenfeldern in jeder Kombination verwendet werden. Die Nachteile eines an der Substrathalteraußenoberfläche angebrachten Positionsmarkenfeldes wurden ausführlich im Abschnitt Positionsmarkenfeld beschrieben. Auf allgemeinen Typ 4 Ausrichtungsanlagen wird daher im weiteren Verlauf der Druckschrift nur oberflächlich eingegangen werden. Eine Typ 4 Ausrichtungsanlage wäre beispielsweise die Ausrichtungsanlage in der Druckschrift WO2011042093A1. Diese Druckschrift beschreibt eine Ausrichtungsanlage, in der ein Substrathalter sich über sehr weite Strecken auf einer Basis bewegen kann, bei der die Ausrichtungsoptiken entweder an der Basis und/oder am Substrathalter befestigt sind etc.

Bevorzugt ist Ausrichtungsanlage des Typ 3 mit den entsprechenden mit den erfindungsgemäßen Erweiterungen.

In einer ganz besonders bevorzugten Ausführungsform verfügt die Vorrichtung über mindestens vier Ausrichtungsoptiken und mindestens eine Positionsoptik, vorzugsweise aber zwei Positionsoptiken. Auf Grund von Symmetrieaspekten werden in der Druckschrift, insbesondere in den Figuren, immer zwei Positionsoptiken verwendet, obwohl eine ausreichen würde.

In einer Ausführungsform ist mindestens einer der Substrathalter als Substrathalter, d.h. mit einem Positionsmarkenfeld, ausgestattet.

In einer ganz besonders bevorzugten Ausführungsform sind beide Substrathalter mit einem Positionsmarkenfeld, ausgestattet. Entsprechend kann die exakte Position eines jeden Substrathalters mit entsprechenden Positionsoptiken bestimmt werden. Entsprechend mehr Positionsoptiken, also mindestens zwei, eine oben und eine unten, werden benötigt.

Die Vorrichtung und das Verfahren sind im Allgemeinen in keiner Art und Weise an irgendeinen der genannten Typen von Ausrichtungsanlagen gebunden. Die grundsätzliche Idee besteht in der Vermessung und der Herstellung einer Korrelation von Ausrichtungsmarken zu Positionsmarken in Positionsmarkenfeldern. Dennoch werden Vorrichtungen und Prozesse für die unterschiedlichen Ausführungstypen explizit beschrieben und in den Figuren dargestellt. Insbesondere soll die Idee dazu dienen, die Ausrichtungsanlage des Typs 3, der WO2015082020A1 zu erweitern.

### Verfahren

Es ist irrelevant, ob sich der erweiterte oder die erweiterten Substrathalter an der Ober- oder Unterseite der Vorrichtung befinden. Um mit den Figuren der Druckschrift konsistent zu bleiben, wird in der weiteren Beschreibung davon ausgegangen, dass sich bei dem Substrathalter um einen Oberseitensubstrathalter handelt, d.h. das Positionsmarkenfeld zeigt in Richtung der Gravitation nach unten.

Den Verfahren geht im Allgemeinen ein Kalibrierverfahren voraus. Das Kalibrierverfahren sollte jedes Mal durchgeführt werden, wenn davon auszugehen ist, dass sich die optischen Systeme geändert haben oder verstellt wurden. Die Kalibrierprozesse sind abhängig vom verwendeten Typ der Ausrichtungsanlage. Mögliche Kalibrierprozesse werden beispielsweise ausführlich in den Druckschriften WO2014202106A1 und WO2015082020A1 offenbart und werden hier nicht näher abgehandelt.

Nachdem der, für die jeweilige Ausrichtungsanlage vorgesehene, Kalibrierprozess abgeschlossen wurde, kann insbesondere der Ausrichtungsprozess beginnen.

Die Methode ist grundsätzlich auf Ausrichtungsanlagen anwendbar, bei denen sich die Substrate insbesondere entlang einer Richtung bewegen die (i) normal auf die Verbindungslinie zweier Ausrichtungsmarken und (ii) parallel zur Substratoberfläche liegt. Diese Ausrichtungsanlage wird in der US6214692B1 beschrieben und als Typ 1 bezeichnet. Die Substrate müssen dabei relativ lange Wege zurücklegen um die Ausrichtungsmarken für die Optiken sichtbar zu machen. Die Ausrichtungsmarken werden hier quasi "parallel" vermessen.

In einem **ersten** Prozessschritt in einem beispielhaften erfindungsgemäßen Verfahren zur Ausrichtung von zwei Substraten mit einer Ausrichtungsanlage des Typ 1 wird ein erstes Substrat auf einen ersten, oberen Substrathalter geladen und fixiert.

In einem **zweiten** Prozessschritt wird der erste, obere Substrathalter solange verschoben, bis sich die Ausrichtungsmarken des ersten, oberen Substrats in den Sichtbereichen der unteren Ausrichtungsoptiken befinden. Insbesondere gleichzeitig vermessen die unteren Positionsoptiken die oberen Positionsmarken des oberen Positionsmarkenfeldes am ersten, oberen Substrathalter, die sich in deren Sichtbereichen befinden. Von diesem Zeitpunkt an, kann der erste, obere Substrathalter entlang der vollen Länge verschoben werden und durch die erneute Ansteuerung der oberen Positionsmarken in dieselbe Position gebracht werden.

In einem **dritten** Prozessschritt verfährt der erste, obere Substrathalter nun soweit, dass die oberen Ausrichtungsoptiken, die er bis dahin verdeckt hat, freie Sicht nach unten haben. Insbesondere gleichzeitig oder bereits parallel zu einem früheren Prozessschritt wird ein zweites Substrat auf einen zweiten, unteren Substrathalter geladen und fixiert. Das Laden des zweiten Substrats kann natürlich auch schon zu einem viel früheren Zeitpunkt, insbesondere parallel zu einem der oben genannten Prozessschritte erfolgen.

In einem **vierten** Prozessschritt wird der zweite, untere Substrathalter solange verschoben, bis sich die Ausrichtungsmarken des zweiten, unteren Substrats in den Sichtbereichen der oberen Ausrichtungsoptiken befinden. Danach wird der zweite, untere Substrathalter vorzugsweise nicht mehr bewegt.

In einem **fünften** Prozessschritt wird der erste, obere Substrathalter wieder in die im zweiten Prozessschritt ermittelte Position zurückverschoben. Dabei werden nun nur mehr die unteren Positionsoptiken verwendet, die das obere Positionsmarkenfeld am ersten, oberen Substrathalter kontinuierlich vermessen und so die gewünschte Position genauestens ansteuern können. Insbesondere erfolgt auch noch die Feinjustierung über die Positionsoptiken, die in anderen Teilen der Druckschrift ausführlicher behandelt wird.

In weiteren Prozessschritten werden die beiden Substrate dann durch einen entsprechenden Prozess miteinander verbunden. Auf den Verbindungsprozess wird hier nicht näher eingegangen. Denkbar sind Fusionsbondprozesse, bei denen eines der beiden Substrate, insbesondere das obere durch ein Krümmungsmittel gekrümmt wird um mit dem anderen Substrat zu kontaktieren.

Eine erste mögliche optionale Verbesserung des oben genannten Prozesses wird hier in verkürzter Form dargestellt. Der obere Substrathalter besitzt Öffnungen durch welche die oberen Ausrichtungsoptiken auf den unteren Substrathalter und damit auf ein unteres, geladenes Substrat blicken können. Der untere Substrathalter verfügt an seiner Rückseite über ein Positionsmarkenfeld. Ein Substrat wird auf den unteren Substrathalter geladen und werden die Ausrichtungsmarken des unteren Substrats durch die Öffnungen des oberen Substrathalters mit Hilfe der oberen Ausrichtungsoptiken vermessen. Gleichzeitig vermessen untere Positionsoptiken das Positionsmarkenfeld auf der Rückseite des unteren Substrathalters. Danach wird das obere Substrat geladen. Insbesondere gleichzeitig verfährt der untere Substrathalter soweit, dass die unteren Ausrichtungsoptiken die Ausrichtungsmarken des oberen Substrats am oberen Substrathalter vermessen können. Der untere Substrathalter kann dann wieder mit Hilfe der Positionsoptiken in die korrekte Position gebracht werden.

Eine zweite mögliche optionale Verbesserung des oben genannten Prozesses wird hier in verkürzter Form dargestellt. Der untere Substrathalter besitzt Öffnungen durch welche die unteren Ausrichtungsoptiken auf den oberen Substrathalter und damit auf ein oberes, geladenes Substrat blicken können. Der obere Substrathalter verfügt an seiner Rückseite über ein Positionsmarkenfeld. Ein Substrat wird auf den oberen Substrathalter geladen und werden die Ausrichtungsmarken des oberen Substrats durch die Öffnungen des unteren Substrathalters mit Hilfe der unteren Ausrichtungsoptiken vermessen. Gleichzeitig vermessen obere Positionsoptiken das Positionsmarkenfeld auf der Rückseite des oberen Substrathalters. Danach wird das untere Substrat geladen. Insbesondere gleichzeitig verfährt der obere Substrathalter soweit, dass die oberen Ausrichtungsoptiken die Ausrichtungsmarken des unteren Substrats am unteren Substrathalter vermessen können. Der obere Substrathalter kann dann wieder mit Hilfe der Positionsoptiken in die korrekte Position gebracht werden.

Eine Kombination der beiden aufgeführten Verbesserungen ist ebenfalls denkbar.

Eine verbesserte Ausführungsform einer Ausrichtungsanlage und damit auch eines verbesserten Verfahrens wird in der WO2014202106A1 beschrieben und als Typ 2 bezeichnet. Hier werden die Substrate auch zueinander verschoben, allerdings entlang der Richtung der Verbindungslinie zweier Ausrichtungsmarken, also "seitlich", sodass immer jeweils eine erste Ausrichtungsmarke eines ersten Substrats von einer zweiten Ausrichtungsoptik und gleichzeitig eine zweite Ausrichtungsmarke eines zweiten Substrats von einer ersten Ausrichtungsoptik erfasst werden kann. Die Ausrichtungsmarken werden hier quasi "überkreuzt" vermessen. Entsprechend ergeben sich leichte Änderungen im Prozessfluss. Dabei ist insbesondere auch mindestens ein Substrathalter der Ausrichtungsanlage des Typs 2 um ein Positionsmarkenfeld erweitert.

In einem **ersten** Prozessschritt in einem beispielhaften erfindungsgemäßen Verfahren zur Ausrichtung von zwei Substraten mit einer Ausrichtungsanlage des Typ 2 wird ein erstes Substrat auf einen ersten, oberen Substrathalter geladen und fixiert. Insbesondere gleichzeitig wird ein zweites Substrat auf einen zweiten, unteren Substrathalter geladen und fixiert. Nach dem Laden und Fixieren der Substrate werden die Substrathalter in eine Position gebracht, in der eine linke, untere Ausrichtungsoptik eine linke, obere Ausrichtungsmarke eines oberen Substrats in deren Sichtbereich hat. Dazu ist es notwendig, dass der untere Substrathalter so weit nach rechts verschoben wird, dass die linke, untere Ausrichtungsoptik freie Sicht auf die linke, obere Ausrichtungsmarke hat. Gleichzeitig muss die linke untere Positionsoptik, eine linke obere Positionsmarke in ihrem Sichtbereich haben. Damit ist die Korrelation zwischen der linken, oberen Positionsmarke und der linken oberen Ausrichtungsmarke hergestellt.

In einem **zweiten** Prozessschritt verfährt der untere Substrathalter nun nach links und erlaubt damit der rechten, unteren Ausrichtungs- und Positionsoptik die Vermessung der rechten, oberen Ausrichtungs- und Positionsmarke. Damit ist die Korrelation zwischen der rechten, oberen Positionsmarke und der rechten oberen Ausrichtungsmarke hergestellt.

In einem **dritten** Prozessschritt wird der zweite, untere Substrathalter solange verschoben, bis sich die linke Ausrichtungsmarke des zweiten, unteren Substrats im Sichtbereich der oberen, linken Ausrichtungsoptik befindet. Dazu kann insbesondere eine Öffnung im oberen Substrathalter vorgesehen sein. Danach wird der zweite, untere Substrathalter vorzugsweise nicht mehr bewegt. Die momentan noch durch den ersten, oberen Substrathalter verdeckte rechte Ausrichtungsmarke des unteren Substrats sollte sich dabei insbesondere im Sichtbereich der rechten oberen Ausrichtungsoptik befinden, sobald der obere Substrathalter die Sicht auf die untere rechte Ausrichtungsmarke freigibt.

In einem **vierten** Prozessschritt verfährt nun der erste, obere Substrathalter solange auf die gegenüberliegende, linke Seite, bis die obere, rechte Ausrichtungsoptik an ihm vorbei auf die untere rechte Ausrichtungsmarke des unteren Substrats blicken kann. Dazu kann insbesondere ebenfalls eine Öffnung im oberen Substrathalter vorgesehen sein. Diese Ausrichtungsmarke sollte sich eigentlich schon im Sichtbereich der rechten oberen Ausrichtungsoptik befinden. Sollte dem nicht so sein, wurden die Optiken vorher auf die eine insbesondere falsche Distanz kalibriert. Die obere, rechte Ausrichtungsoptik vermisst nun die untere, rechte Ausrichtungsmarke. Der untere Substrathalter sollte nun nicht mehr bewegt werden.

In einem **fünften** Prozessschritt wird der erste, obere Substrathalter wieder in die Position zurückverschoben, in der die linke, untere und die rechte, untere Positionsoptik die Positionsmarken des linken und rechten Positionsmarkenfeldes im Sichtbereich haben. Dabei werden nun nur mehr die unteren Positionsoptiken verwendet, die das obere Positionsmarkenfeld am ersten, oberen Substrathalter vermessen und so die gewünschte Position genauestens ansteuern können. Es ist auch von fundamentaler Bedeutung zu verstehen, dass es nicht notwendig ist, dass die unteren Positionsoptiken die beiden Positionsmarkenfelder des ersten, oberen Substrathalter durchgehend im Sichtfeld haben müssen. Sobald die Positionsmarken der Positionsmarkenfelder wieder in den Sichtfeldern der unteren Positionsoptiken erscheinen, kann man zuerst über die Grobpositionierung die gewünschte Position genau und schnell ansteuern. Insbesondere erfolgt auch noch die Feinjustierung über die Positionsoptiken, die in anderen Teilen der Druckschrift ausführlicher behandelt wird.

In weiteren Prozessschritt werden die beiden Substrate dann durch einen entsprechenden Prozess miteinander verbunden. Auf den Verbindungsprozess wird hier nicht näher eingegangen. Denkbar sind Fusionsbondprozesse, bei denen eines der beiden Substrate, insbesondere das obere durch ein Krümmungsmittel gekrümmt wird um mit dem anderen Substrat zu kontaktieren.

Im nächsten Abschnitt wird ein besonders bevorzugter Prozess für eine Typ 3 Ausrichtungsanlage beschrieben. Dieser Typ von Ausrichtungsanlage wird in der Druckschrift WO2015082020A1 beschrieben. Die Anwendung der erfindungsgemäßen Aspekte auf diesen Typ von Ausrichtungsanlage ist von besonderer Bedeutung, da diese Ausrichtungsanlage den neuesten Stand der Technik darstellt. Die Ausrichtungsanlage zeichnet sich, wie der vorher beschriebene Typ 2, vor allem durch sehr kurze Verschiebungen der Substrathalter aus. Allerdings werden hier die unteren Bauteile, d.h. die unteren Ausrichtungsoptiken und der untere Substrathalter so konzipiert, dass sie sich insbesondere nur entlang der z-Richtung, also entlang der Höhe verstellen lassen, während die oberen Ausrichtungsoptiken und der obere Substrathalter maximale Anzahl von Freiheitsgraden besitzen, insbesondere in x und y Richtung. Die Vorteile die sich daraus ergeben sind ausführlich in der Druckschrift WO2015082020A1 beschrieben.

Ein wesentliches Merkmal der erweiterten Typ 3 Ausrichtungsanlage besteht darin, dass sich die Positionsmarkenfelder entlang einer Linie befinden, die nicht parallel, insbesondere normal, auf die Verbindungslinie der später zu vermessenden Ausrichtungsmarken steht.

In einem **ersten** Prozessschritt in einem beispielhaften erfindungsgemäßen Verfahren zum Ausrichten von zwei Substraten mit einer Ausrichtungsanlage des Typ 3 verfährt der obere Substrathalter nach links. Insbesondere gleichzeitig verfährt eine linke Ausrichtungsoptik in z-Richtung nach oben, bis sie die linke Ausrichtungsmarke des oberen Substrats in ihrem Sichtfeld und Schärfentiefebereich hat. Insbesondere gleichzeitig verfährt auch mindestens eine Positionsoptik nach oben, bis mindestens eine Positionsmarke von einem der Positionsmarkenfelder sichtbar ist. Damit wird es möglich, mindestens eine Positionsmarke von mindestens einem der Positionsmarkenfelder mit der linken Ausrichtungsmarke zu assoziieren beziehungsweise in Korrelation zueinander zu setzen.

In einem **zweiten** Prozessschritt verfährt der obere Substrathalter nach rechts. Insbesondere gleichzeitig verfährt eine rechte Ausrichtungsoptik 6ur in z-Richtung nach oben, bis sie die rechte Ausrichtungsmarke des oberen Substrats in ihrem Sichtfeld und Schärfentiefebereich hat. Insbesondere gleichzeitig verfährt auch mindestens eine Positionsoptik nach oben, bis mindestens eine Positionsmarke von einem der Positionsmarkenfelder sichtbar ist. Denkbar ist, dass sich die zwei Positionsoptiken bereits durch den ersten Prozessschritt in Position befinden. Denkbar ist auch, dass nur eine der Positionsoptiken im ersten Prozessschritt mit der linken Ausrichtungsoptik verbunden waren und daher jetzt die entsprechend zweite Positionsoptik in Position gebracht werden muss. Sollte die Ausführungsform nur auf eine Positionsoptik zurückgreifen, befindet sich diese durch den ersten Prozessschritt schon in Position und vermisst nun eine zweite Positionsmarke desselben Positionsmarkenfeldes. Damit wird es möglich, mindestens eine weitere Positionsmarke mit der rechten Ausrichtungsmarke zu assoziieren.

In einem **dritten** Prozessschritt verfährt der untere Substrathalter nach oben. Insbesondere gleichzeitig verfährt die obere linke Ausrichtungsoptik in, im Allgemeinen, mehrere Richtungen um die untere Ausrichtungsmarke des unteren Substrats in den Sichtbereich und Schärfentiefebereich zu bekommen.

In einem **vierten** Prozessschritt verfährt der Substrathalter nach links. Insbesondere gleichzeitig verfährt die obere rechte Ausrichtungsoptik in, im Allgemeinen, mehrere Richtungen um die untere Ausrichtungsmarke des unteren Substrats in den Sichtbereich zu bekommen.

In einem **fünften** Prozessschritt wird nun der obere Substrathalter zum unteren Substrathalter so ausgerichtet, dass die oberen Ausrichtungsmarken möglichst deckungsgleich zu den unteren Ausrichtungsmarken sind. Dabei wird die Bewegung des oberen Substrathalters durch mindestens eine der Positionsoptiken überprüft, in dem mindestens eines der Positionsmarkenfelder insbesondere kontinuierlich ausgelesen und ausgewertet wird. Insbesondere wird eine Feinpositionierung über die Pixel durchgeführt. Es ist daher möglich, das obere Substrat zum unteren Substrat auszurichten, obwohl die Ausrichtungsmarken durch die jeweils gegenüberliegenden Substrate verdeckt werden und nicht mehr sichtbar sind.

Eine um die erfindungsgemäßen Aspekte erweiterte Ausrichtungsanlage kann insbesondere auf allen Ausrichtungsanlagetypen basieren. Die entsprechenden Verfahren sind aber von den entsprechenden Prozessschritten leicht unterschiedlich, sodass für jeden der beiden genannten Ausrichtungstypen das Verfahren in den Figuren explizit beschrieben wird.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen in:
- Figur 1: einen ersten erfindungsgemäßen Substrathalter,
- Figur 2: einen zweiten erfindungsgemäßen Substrathalter,
- Figur 3: einen dritten erfindungsgemäßen Substrathalter,
- Figur 4: einen vierten erfindungsgemäßen Substrathalter,
- Figur 5a: einen ersten Prozessschritt in einer ersten erfindungsgemäßen Ausrichtungsanlage,
- Figur 5b: einen zweiten Prozessschritt in einer ersten Ausrichtungsanlage,
- Figur 5c: einen dritten Prozessschritt in einer ersten Ausrichtungsanlage,
- Figur 5d: einen vierten Prozessschritt in einer ersten Ausrichtungsanlage,
- Figur 5e: einen fünften Prozessschritt in einer ersten Ausrichtungsanlage,
- Figur 6a: einen ersten Prozessschritt in einer zweiten erfindungsgemäßen Ausrichtungsanlage,
- Figur 6b: einen zweiten Prozessschritt in einer zweiten Ausrichtungsanlage,
- Figur 6c: einen dritten Prozessschritt in einer zweiten Ausrichtungsanlage,
- Figur 6d: einen vierten Prozessschritt in einer zweiten Ausrichtungsanlage,
- Figur 6e: einen fünften Prozessschritt in einer zweiten Ausrichtungsanlage,
- Figur 7a: einen ersten Prozessschritt in einer dritten erfindungsgemäßen Ausrichtungsanlage,
- Figur 7b: einen zweiten Prozessschritt in einer dritten Ausrichtungsanlage,
- Figur 7c: einen dritten Prozessschritt in einer dritten Ausrichtungsanlage,
- Figur 7d: einen vierten Prozessschritt in einer dritten Ausrichtungsanlage,
- Figur 7e: einen fünften Prozessschritt in einer dritten Ausrichtungsanlage,
- Figur 8a: einen ersten Prozessschritt eines Feinausrichtungsprozesses und
- Figur 8b: einen zweiten Prozessschritt eines Feinausrichtungsprozesses.

In den Figuren sind gleiche Bauteile oder Bauteile mit der gleichen Funktion mit den gleichen Bezugszeichen gekennzeichnet.

Sämtliche Figuren stellen Bauteile und deren Merkmale ausschließlich schematisch in einer prinzipiellen, skizzenhaften Art dar. Die Figuren sind weder maßstabsgetreu noch sind Merkmale der Bauteil notwendigerweise so konstruiert wie dargestellt. Die Figuren sind daher nur als Prinzip Skizzen zu verstehen und deren Merkmale sind unter allen Umständen funktional zu interpretieren.

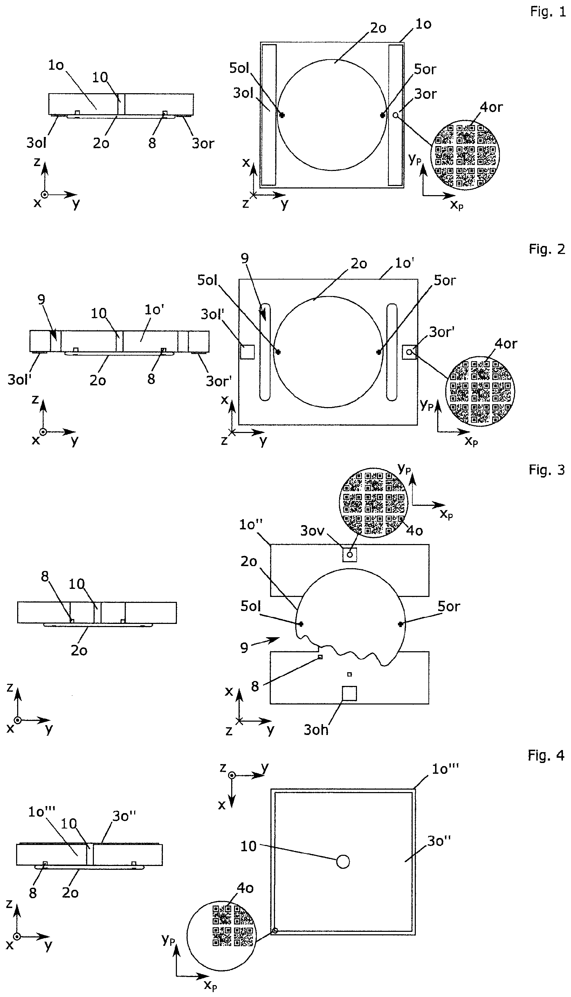

Die **Figur 1** zeigt einen ersten Substrathalter 1o, mit Positionsmarkenfeldern 3ol, 3or, bestehend aus mehreren Positionsmarken 4ol, 4or auf dem ein Substrat 2o mit Ausrichtungsmarken 5ol, 5or fixiert wurde. Dargestellt werden nur die Positionsmarken 4or in der Vergrößerung auf der rechten Seite. Entsprechend existieren Positionsmarken 4ol auf der linken Seite, deren Vergrößerung auf Grund der Anschaulichkeit und Übersichtlichkeit nicht dargestellt wird. Die Positionsmarkenfelder 3ol, 3or befinden sich auf der Substrathalterfixierseite, d.h. auf derselben Seite wie das fixierte Substrat 2o. Entsprechend können sich die Positionsmarkenfelder 3ol, 3or nur außerhalb des Fixierbereichs für das Substrat 2o befinden. Die Positionsmarkenfelder 3ol, 3or sind insbesondere entlang einer Richtung über die gesamte Länge des Substrathalters 1 vorhanden, im vorliegenden Fall entlang der x-Richtung. Es wird allerdings nochmal erwähnt, dass auch für die Anpassung des Typ 1 Ausrichtungsanlage derartige lange Positionsmarkenfelder 3ol, 3or nicht notwendig sind und sie genauso eine Größe wie die Positionsmarkenfelder 3ol, 3or (siehe Fig. 2) in der Erweiterung einer Typ 2 Ausrichtungsanlage haben können. Da der Substrathalter 1o der Typ 1 Ausrichtungsanlage, die in der Figurenserie 4a-4f beschrieben wird, allerdings weitere Strecken zurückleget, werden die Positionsmarkenfelder 3ol, 3or als zusätzliche Erweiterung entlang der gesamten x-Richtung ausgeführt dargestellt. Dieser Substrathalter 1o wird für Ausrichtungsanlagen des Typs 1 verwendet. Der Substrathalter 1o verfügt über Fixierelemente 8, sowie ein Verformungselement 10. Diese werden auch nur rudimentär erwähnt und beschrieben, da sie für den Gedanken nicht von essentieller Bedeutung sind.

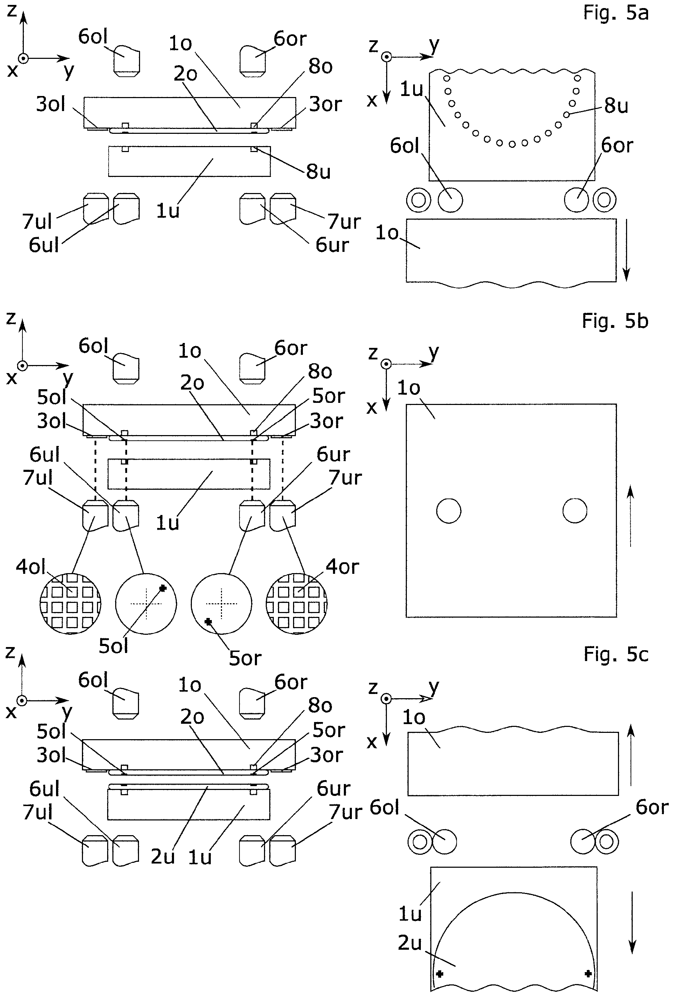

Die **Figur 2** zeigt einen zweiten, bevorzugteren Substrathalter 1o', mit Positionsmarkenfeldern 3ol', 3or', bestehend aus mehreren Positionsmarken 4ol, 4or auf dem ein Substrat 2o mit Ausrichtungsmarken 5ol, 5or fixiert wurde. Dargestellt werden nur die Positionsmarken 4or in der Vergrößerung auf der rechten Seite. Entsprechend existieren Positionsmarken 4ol auf der linken Seite, deren Vergrößerung auf Grund der Anschaulichkeit und Übersichtlichkeit nicht dargestellt wird. Die Positionsmarkenfelder 3ol', 3or' befinden sich auf der Substrathalterfixierseite, d.h. auf derselben Seite wie das fixierte Substrat 2o. Entsprechend können sich die Positionsmarkenfelder 3ol', 3or' nur außerhalb des Fixierbereichs für das Substrat 2o befinden. Der Substrathalter 1o' weist vorzugsweise auch Öffnungen 9, bei denen es sich insbesondere um volldurchgängige Ausfräsungen, Langlöcher, Löcher oder Bohrungen handelt, auf, durch die Ausrichtungsoptiken 5ol, 5or durch den Substrathalter 1o' blicken können. Die Öffnungen 9 vereinfachen insbesondere den Prozess, der in den Figuren 5a-5e dargestellt wird. Insbesondere werden dadurch die notwendigen, wechselseitigen Verschiebungen der Substrathalter 1o',1u kürzer. Der Prozess lässt sich auch ohne die Öffnungen 9 realisieren, ist dann aber weniger effizient, da in diesem Fall die notwendigen, wechselseitigen Verschiebungen der Substrathalter 1o',1 um einiges länger sind. Der Vollständigkeit halber werden daher die Öffnungen 9 immer eingezeichnet. Dieser Substrathalter 1o' wird vor allem für Ausrichtungsanlagen des Typ 2 und Typ 3 verwendet. Die Positionsmarkenfelder 3ol', 3or'sind kleiner als die Positionsmarkenfelder 3ol, 3or in der Figur 1. Der Substrathalter 1o' verfügt ebenfalls über Fixierelemente 8, sowie ein Verformungselement 10. Diese werden auch nur rudimentär erwähnt und beschrieben, da sie für den Gedanken nicht von essentieller Bedeutung sind.

Die **Figur 3** zeigt einen dritten, noch bevorzugteren Substrathalter 1o'', mit einem vorderen und einem hinteren Positionsmarkenfeld 3ov, 3oh bestehend aus mehreren Positionsmarken 4o. Erkennbar ist, dass die Verbindungslinie zwischen den Positionsmarkenfeldern 3ov, 3oh nicht parallel zur Verbindungslinie zwischen den beiden Ausrichtungsmarken 5ol, 5or liegt, die Positionsmarkenfeldern 3ov, 3oh um 90° gedreht zu den Ausrichtungsmarken 5ol, 5or vorliegen. Ein charakteristisches Merkmal des Substrathalters 1o" ist, dass sich die Ausrichtungsmarken 5ol, 5or des oberen Substrats 2o nicht in Linie mit den Positionsmarkenfeldern 3ov, 3oh befinden, die daher mit den Indizes v (vorne) und h (hinten) bezeichnet werden. Diese Nomenklatur erleichtert in den weiteren Figurenbeschreibungen die Erklärungen. Der Substrathalter 1o" verfügt ebenfalls über Fixierelemente 8, sowie ein Verformungselement 10. Diese werden auch nur rudimentär erwähnt und beschrieben, da sie für den Gedanken nicht von essentieller Bedeutung sind. Der zweite Substrathalter 1o" verfügt ebenfalls über Öffnungen 9, die den Ausrichtungsoptiken einen sehr nahen Zugang zur Peripherie des Substrats 2o gewähren. Das wird im später erklärten Prozess wichtig für das Verfahren sein.

Die **Figur 4** zeigt einen vierten, weniger bevorzugten Substrathalter 1o‴, mit einem einzigen Positionsmarkenfeld 3o", bestehend aus mehreren Positionsmarken 4o auf dem ein Substrat 2o mit Ausrichtungsmarken 5ol, 5or fixiert wurde. Das Positionsmarkenfeld 3o'' befindet sich auf der Substrathalteraußenseite. Entsprechend kann das Positionsmarkenfeld 3o" über einen sehr großen Flächenbereich erstellt werden. Dieser Substrathalter 1o‴ kann für alle Typen von Ausrichtungsanlagen verwendet werden. Nachteilig bei dieser Ausführungsform ist vor allem die Tatsache, dass die Schärfentiefebereiche der verwendeten Ausrichtungsoptiken (nicht eingezeichnet) und der Positionsoptiken (nicht eingezeichnet) nicht auf derselben Höhe liegen können. Die Schärfentiefebereichen sind mindestens durch die Höhe h des Substrathalters 1o‴ voneinander getrennt. Dadurch sind auch die Fokusebenen der Ausrichtungsmarken 5ol, 5or und der Positionsmarken 4o entsprechend weit voneinander entfernt. Das Positionsmarkenfeld 3o" muss natürlich nicht über die gesamte Substrataußenoberfläche des Substrathalters 1o‴ ausgedehnt sein, sondern kann lokalisiert und kleiner sein. Die Ausdehnung über eine sehr große Fläche ist nur eine weitere Ausführungsform. Der Substrathalter 1o‴ verfügt ebenfalls über Fixierelemente 8, sowie ein Verformungselement 10. Diese werden auch nur rudimentär erwähnt und beschrieben, da sie für den Gedanken nicht von essentieller Bedeutung sind.

Die folgenden Figurenbeschreibungen dienen der Darstellung eines Prozesses, insbesondere für Vorrichtungen des Typ 1.

Der besseren Übersichtlichkeit halber werden die Figuren 5a-5e nicht geschnitten.

Die **Figur 5a** zeigt einen ersten Prozessschritt eines ersten Prozesses in einer Seitendarstellung (links) und einer Oberansicht (rechts). Ein oberer Substrathalter 1o, mit einem Positionsmarkenfeld 3ol auf der linken und einem Positionsmarkenfeld 3or auf der rechten Seite, verfährt in eine Ladeposition um ein Substrat 2o aufzunehmen und zu fixieren. Denkbar wäre auch, dass das Substrat 2o am Substrathalter 1o fixiert wird, ohne dass dieser sich bewegt. Entsprechend müsste ein Roboter das Substrat 2o in die entsprechende Position bewegen, in der es vom oberen Substrathalter 1o fixiert werden kann. Die Vorrichtung verfügt insbesondere über zwei obere Ausrichtungsoptiken 6ol, 6or, zwei untere Ausrichtungsoptiken 6ul, 6ur und zwei untere Positionsoptiken 7ul, 7or. In der Aufsicht sind am unteren Substrathalter 1u die Fixierelemente 8u erkennbar, mit denen ein unteres Substrat 2u (nicht eingezeichnet) in einem späteren Prozessschritt fixiert wird. Die Ausrichtungsoptiken 6ol, 6or wurden bereits zu den untere Ausrichtungsoptiken 6ul, 6ur kalibriert gemäß einem Verfahren aus dem Stand der Technik.

Die **Figur 5b** zeigt einen zweiten Prozessschritt eines ersten Prozesses. Der Substrathalter 1o verfährt solange in x-Richtung, bis die Ausrichtungsmarken 5ol, 5or von den Ausrichtungsoptiken 6ul, 6ur sowie mindestens eine Positionsmarke 4ol, 4or pro Positionsmarkenfeld 3ol, 3or sich von den Positionsoptiken 7ul, 7ur erfasst werden. Die Positionsmarken 4ol, 4or werden in den Figuren nur mehr abstrahiert als Rechteck dargestellt um die Darstellung zu vereinfachen. Da sich die Ausrichtungsoptiken 6ul, 6ur sowie die Positionsoptiken 7ul, 7ur nicht mehr bewegen, kann durch die Vermessung der Positionsmarken 4ol, 4or der Positionsmarkenfelder 3ol, 3or jederzeit bestimmt werden, wo sich die Ausrichtungsmarken 5ol, 5or befinden in Bezug zu den optischen Achsen der Ausrichtungsoptiken 6ol, 6or, 6ul, 6ur befinden. Dabei muss erneut erwähnt werden, dass die Schärfentiefebereiche der optischen Achsen der Ausrichtungsoptiken 6ol, 6or, 6ul, 6ur in vorhergehenden Kalibrierprozessen ja vorzugsweise auf eine Fokuseben kalibriert worden sind. Der Schnittpunkt der Schärfentiefebereiche der beiden linken Ausrichtungsoptiken 6ol, 6ul stellt den Nullpunkt für die linke Seite und der Schnittpunkt der Schärfentiefebereiche der beiden rechten Ausrichtungsoptiken 6or, 6ur stellt den Nullpunkt für die rechte Seite der Vorrichtung dar.

Die **Figur 5c** zeigt einen dritten Prozessschritt eines ersten Prozesses. Der obere Substrathalter 1o verfährt soweit, dass er den oberen Ausrichtungsoptiken 6ol, 6or nicht mehr im Wege steht. Insbesondere gleichzeitig verfährt ein untere Substrathalter 1u in eine Ladeposition und wird mit einem unteren Substrat 2u geladen. Der untere Substrathalter 1u fixiert das untere Substrat 2u. Denkbar wäre natürlich auch in diesem Fall, dass sich der untere Substrathalter 1u nicht bewegt und das untere Substrat 2u von einem Roboter, insbesondere positioniert, abgelegt wird. Denkbar ist natürlich auch, dass das untere Substrat 2u bereits vorher auf den unteren Substrathalter 1u geladen wurde.

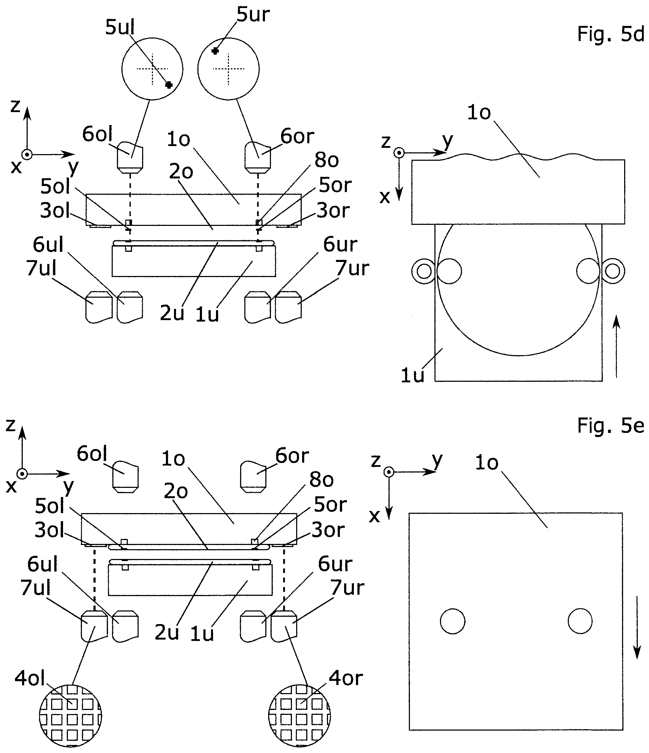

Die **Figur 5d** zeigt einen vierten Prozessschritt eines ersten Prozesses bei dem der untere Substrathalter 1u solange verfährt, bis die untere Ausrichtungsmarken 5ul, 5ur sich im Sichtbereich der oberen Ausrichtungsoptiken 6o1, 6or befinden. Da der obere Substrathalter 1o im vorherigen Prozessschritt aus den Sichtfeldern der oberen Ausrichtungsoptiken 6ol, 6or gefahren wurde, kann die Substratoberfläche des Substrats 2u vermessen werden. Nachdem der untere Substrathalter 1u positioniert wurde, wird er sich nicht mehr bewegt.

Die **Figur 5e** zeigt einen fünften Prozessschritt eines ersten Prozesses bei dem der obere Substrathalter 1o wieder in seine Ausgangsposition zurückverfahren wird. werden die Positionsmarken 4ol, 4or der Positionsmarkenfelder 3ol, 3or ermessen um eine genaue Kenntnis über die Position der, mittlerweile verdeckten oberen Ausrichtungsmarken 5ol, 5or zu erhalten. Die Position der unteren Ausrichtungsmarken 5ul, 5ur müssen ja noch bekannt sein, da sich der untere Substrathalter 1u nicht mehr bewegt hat. Über die Betrachtung der Positionsmarken 4ol, 4or der Positionsmarkenfelder 3ol, 3or ist es daher möglich, die linken Ausrichtungsmarken 5ol, 5ul und die rechten Ausrichtungsmarken 5or, 5ur durch Positionsverschiebung des oberen Substrathalters 1o zur Deckung zu bringen. Der obere Substrathalter 1o kann sich daher vorzugsweise in mehr als nur einen Freiheitsgrad bewegen. In weiteren Prozessschritten erfolgt dann die Annäherung der Substrate 2o, 2u zueinander, sowie deren Bondprozess. Diese Prozessschritte werden nicht mehr explizit dargestellt, da sie insbesondere mit der Idee nichts mehr zu tun haben.

Die folgenden Figurenbeschreibungen dienen der Darstellung eines Prozesses, insbesondere für Vorrichtungen des **Typs 2.** Das charakteristische Merkmal von Typ 2 Ausrichtungsanlagen besteht darin, dass sich die Substrathalter 1o, 1u seitlich, insbesondere überkreuzt, bewegen.

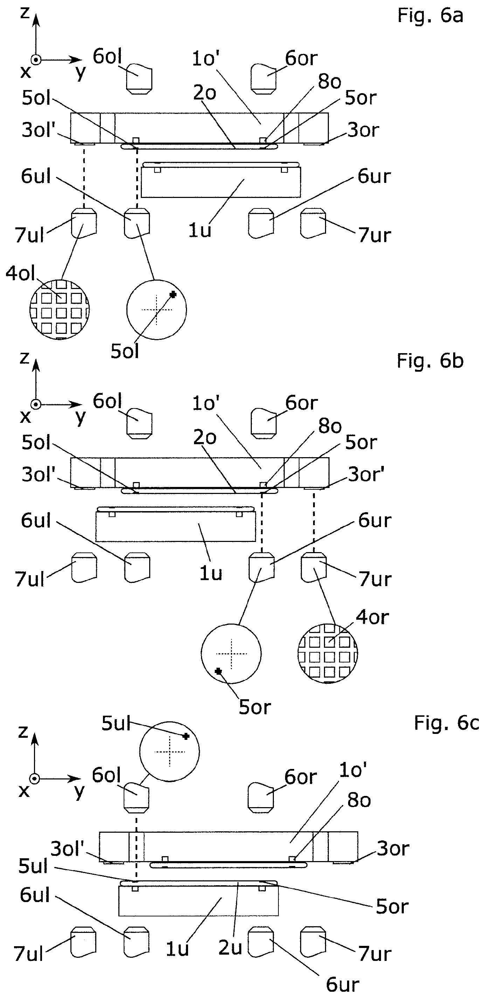

Der besseren Übersichtlichkeit halber werden die Figuren 6a-6e nicht geschnitten.

Die **Figur 6a** zeigt einen ersten Prozessschritt eines zweiten Prozesses bei dem der untere Substrathalter 1u auf eine Seite, insbesondere die rechte Seite, verschoben wird. Die linke Ausrichtungsoptik 6ul vermisst eine linke Ausrichtungsmarke 5ol des oberen Substrats 2o. Gleichzeitig vermisst die linke Positionsoptik 7ul eine linke Positionsmarke 4ol eines linken Positionsmarkenfeldes 3ol'.

Die **Figur 6b** zeigt einen zweiten Prozessschritt eines zweiten Prozesses bei dem der untere Substrathalter 1u auf die gegenüberliegende, insbesondere die linke, Seite verschoben wird. Die rechte Ausrichtungsoptik 6ur vermisst eine rechte Ausrichtungsmarke 5or des oberen Substrats 2o. Gleichzeitig vermisst die rechte Positionsoptik 7ur eine rechte Positionsmarke 4or eines rechten Positionsmarkenfeldes 3or'.

Die **Figur 6c** zeigt einen dritten Prozessschritt eines zweiten Prozesses bei dem der untere Substrathalter 1u wieder in seine ursprüngliche Ausgangsposition verschoben wird. Insbesondere gleichzeitig bewegt sich der obere Substrathalter 1o' solange nach rechts, bis die obere, linke Ausrichtungsoptik 6ol durch die Öffnungen 9 freie Sicht auf die untere Ausrichtungsmarke 5ul des unteren Substrats 2u besitzt. Die Position der untere Ausrichtungsmarke 5ul relativ zur linken optischen Achse wird gespeichert.

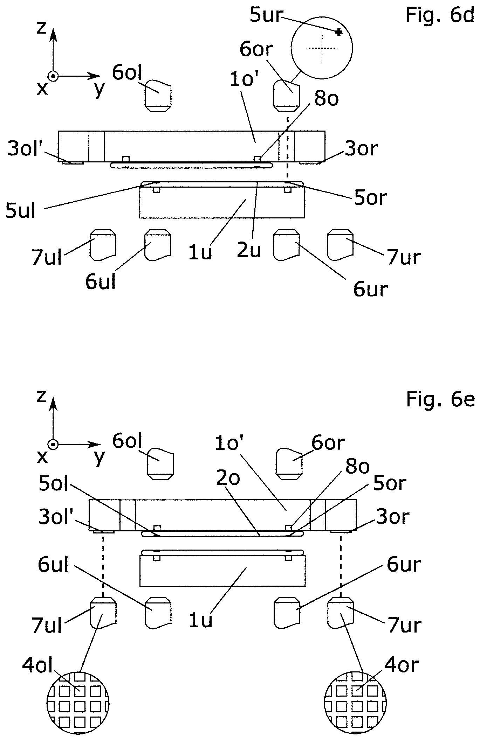

Die **Figur 6d** zeigt einen vierten Prozessschritt eines zweiten Prozesses bei dem der obere Substrathalter 1o' solange nach links bewegt wird, bis die obere rechte Ausrichtungsoptik 6or durch die Öffnungen 9 freie Sicht auf die untere Ausrichtungsmarke 5ur des unteren Substrats 2u besitzt. Die Position der untere Ausrichtungsmarke 5ur relativ zur rechten optischen Achse wird gespeichert.

Die Prozessschritte in den Figuren 5c und 5d setzen voraus, dass der untere Substrathalter in Prozessschritt zwei gemäß Figur 5b so in seine Ursprungsposition zurückverschoben wurde, dass sich die beiden Ausrichtungsmarken 5ul, 5ur in den Sichtbereichen der Ausrichtungsoptiken 6ol, 6or befinden. Sollte das für mindestens eine der Ausrichtungsmarken 5ul, 5ur nicht der Fall sein, muss das untere Substrat 2u entsprechend neu positioniert und die Prozessschritte drei und vier wiederholt werden.

Der Substrathalter 2u darf ab diesem Prozessschritt nicht mehr bewegt werden.

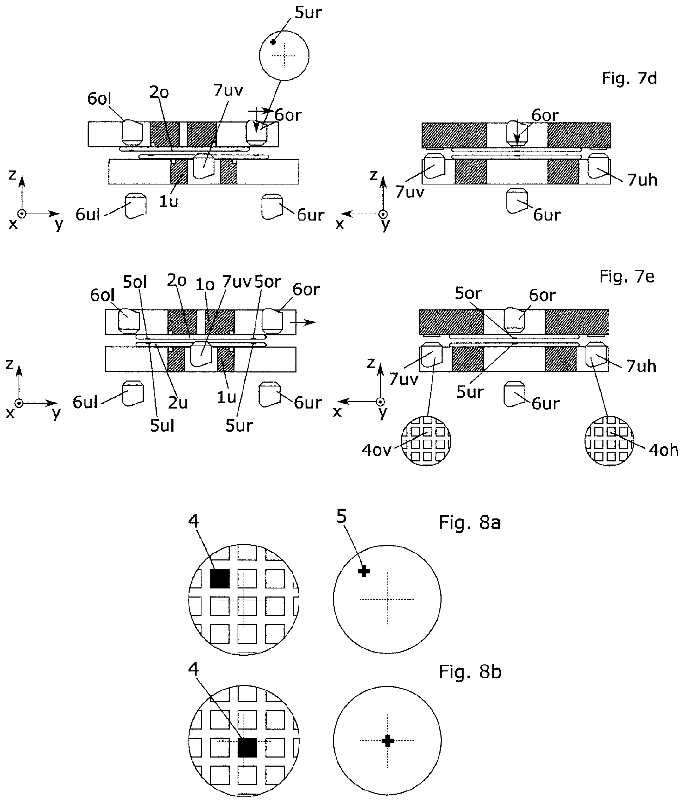

Die **Figur 6e** zeigt einen fünften Prozessschritt eines zweiten Prozesses, bei dem der obere Substrathalter 1o' nun wieder solange in seine ursprüngliche Position zurückgefahren wird, bis die Positionsmarkenfelder 3ol' 3or' in den Sichtfeldern der unteren Positionsoptiken 7ul, 7ur erscheinen. Von diesem Zeitpunkt an können die oberen Ausrichtungsmarken 5ol, 5or, zu den unteren Ausrichtungsmarken 5ul, 5ur ausgereichtet werden, indem die automatische Steuerung den oberen Substrathalter 1o' durch die Positionsvermessung über die Positionsmarken 4ol, 4or in die korrekte Position bringt. Dieser Prozess ist ein Feinjustierungsprozess der in den **Figuren 8a****-b** für alle Typen von Ausrichtungsanlagen genauer beschrieben wird.

In weiteren Prozessschritten erfolgen dann noch die Annäherung und der eigentliche Bondprozess der beiden Substrate. Diese Prozessschritte werden nicht näher beschrieben, da sie für den Gedanken nicht mehr von Relevanz sind.

Die in den Figuren 5a-6e beschriebenen Prozesse für die Typen 1 und 2 beruhen unabhängig vom Gedanken vor allem auf dem Prinzip der Kalibrierung aller Ausrichtungsoptiken auf eine Fokuseben. Die Optiken werden nach der Kalibrierung nicht mehr bewegt.

Gänzlich anders verhält es sich bei der Ausrichtungsanlage vom Typ 3. Hier sind die unteren Ausrichtungsoptiken so konzipiert, dass sie sich ausschließlich in z-Richtung bewegen können, während die oberen Ausrichtungsoptiken sich in x-, y- und vorzugsweise auch in z-Richtung bewegen können. Des Weiteren besitzt der untere Substrathalter ausschließlich eine Beweglichkeit in z-Richtung, während der obere Substrathalter Freiheitsgrade in x-, y- vorzugsweise auch in z-Richtung sowie um drei Rotationsachsen besitzt. Entsprechend wirkt sich der Gedanke auch hier auf die Prozessschritte aus.

In den folgenden Figuren werden in jeder Figur eine Seitenansicht (links), entlang der X-Richtung, und eine Vorderansicht (rechts), entlang der Y-Richtung, dargestellt.

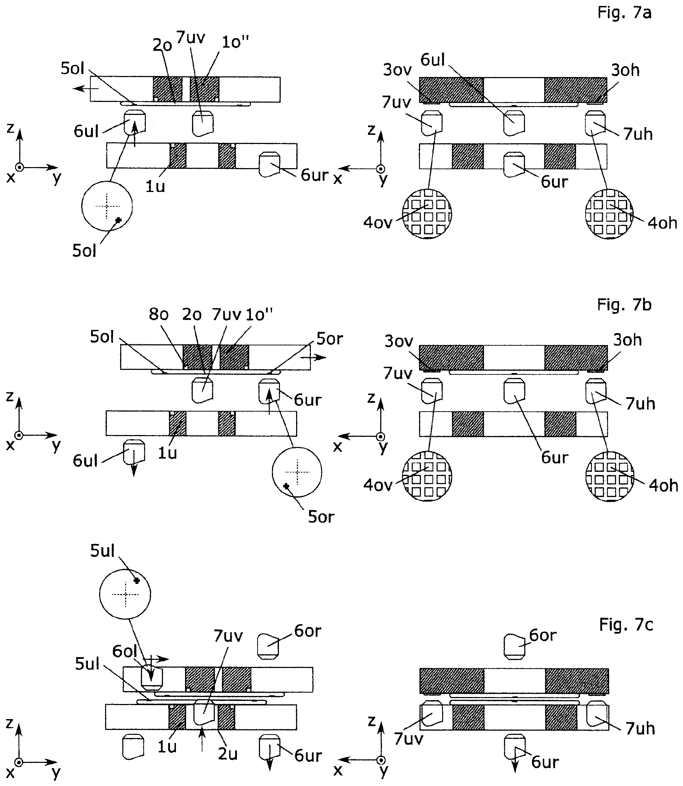

Der besseren Übersichtlichkeit halber werden die Figuren 7a-7e diesmal geschnitten.

Die Ausrichtungsoptiken 6ul, 6ur, 6ol, 6or und die Positionsoptiken 7uv, 7uh sind vorzugsweise alle unabhängig voneinander positionier-, dreh- und steuerbar.

Die **Figur** 7a zeigt einen ersten Prozessschritt eines dritten Prozesses. Der obere Substrathalter 1o" verfährt nach links. Insbesondere gleichzeitig verfährt eine linke Ausrichtungsoptik 6ul in z-Richtung nach oben, bis sie die linke Ausrichtungsmarke 5ol des oberen Substrats 2o in ihrem Sichtfeld und Schärfentiefebereich hat. Insbesondere gleichzeitig verfährt auch mindestens eine Positionsoptik 7uv, 7uh nach oben, bis mindestens eine Positionsmarke 4o von einem der Positionsmarkenfelder 3ov, 3oh sichtbar ist. Damit wird es möglich, mindestens eine Positionsmarke 4o von mindestens einem der Positionsmarkenfelder 3ov, 3oh mit der linken Ausrichtungsmarke 5ol zu assoziieren. Das Verfahren der Ausrichtungsoptik 6ul und der Positionsoptiken 7uv, 7uh ist natürlich nicht notwendig, wenn die Vorrichtung so konstruiert ist, dass der Schärfentiefebereich bereits die Ausrichtungsmarke 5ol und die Positionsmarkenfelder 3ov, 3oh erfassen kann.

Die **Figur 7b** zeigt einen zweiten Prozessschritt eines dritten Prozesses. Der obere Substrathalter 1o" verfährt nach rechts. Insbesondere gleichzeitig verfährt eine rechte Ausrichtungsoptik 6ur in z-Richtung nach oben, bis sie die rechte Ausrichtungsmarke 5or des oberen Substrats 2o in ihrem Sichtfeld und Schärfentiefebereich hat. Insbesondere gleichzeitig verfährt auch mindestens eine Positionsoptik 7uv, 7uh nach oben, bis mindestens eine Positionsmarke 4o von einem der Positionsmarkenfelder 3ov, 3oh sichtbar ist. Denkbar ist, dass sich die zwei Positionsoptiken 7uv, 7uh bereits durch den ersten Prozessschritt in Position befinden. Denkbar ist auch, dass nur eine der Positionsoptiken 7uh, 7uv im ersten Prozessschritt mit der linken Ausrichtungsoptik 6ul verbunden waren und daher jetzt die entsprechend zweite Positionsoptik in Position gebracht werden muss. Sollte die Ausführungsform nur auf eine Positionsoptik 7uv oder 7uh zurückgreifen, befindet sich diese durch den ersten Prozessschritt schon in Position und vermisst nun eine zweite Positionsmarke 4o desselben Positionsmarkenfeldes 3ov oder 3oh. Damit wird es möglich, mindestens eine weitere Positionsmarke 4o mit der rechten Ausrichtungsmarke 5or zu assoziieren. Das Verfahren der Ausrichtungsoptik 6ur und der Positionsoptiken 7uv, 7uh ist natürlich nicht notwendig, wenn die Vorrichtung so konstruiert ist, dass der Schärfentiefebereich bereits die Ausrichtungsmarke 5or und die Positionsmarkenfelder 3ov, 3oh erfassen kann.

Die **Figur** 7c zeigt einen dritten Prozessschritt eines dritten Prozesses. Der untere Substrathalter 1u verfährt nach oben. Insbesondere gleichzeitig verfährt die obere linke Ausrichtungsoptik 6ol in, im Allgemeinen, mehrere Richtungen um die untere Ausrichtungsmarke 5ul des unteren Substrats 2u in den Sichtbereich und Schärfentiefebereich zu bekommen.

Die **Figur 7d** zeigt einen vierten Prozessschritt eines dritten Prozesses. Der obere Substrathalter 1o verfährt nach links. Insbesondere gleichzeitig verfährt die obere rechte Ausrichtungsoptik 6or in, im Allgemeinen, mehrere Richtungen um die untere Ausrichtungsmarke 5ur des unteren Substrats 2u in den Sichtbereich zu bekommen.

Die **Figur** 7e zeigt einen fünften Prozessschritt eines dritten Prozesses. Der obere Substrathalter 1o wird nun zum unteren Substrathalter 1u so ausgerichtet, dass die oberen Ausrichtungsmarken 5ol, 5or möglichst deckungsgleich zu den unteren Ausrichtungsmarken 5ul, 5ur sind. wird dabei die Bewegung des oberen Substrathalters 1o durch mindestens eine der Positionsoptiken 7uv und 7uh überprüft, in dem mindestens eines der Positionsmarkenfelder 3ov, 3oh kontinuierlich ausgelesen und ausgewertet wird. Insbesondere wird eine Feinpositionierung über die Pixel durchgeführt. ist es daher möglich, das obere Substrat 2o zum unteren Substrat 2u auszurichten, obwohl die Ausrichtungsmarken 5ul, 5ur, 5ol, 5or durch die jeweils gegenüberliegenden Substrate verdeckt werden und nicht mehr sichtbar sind.

Die **Figur 8a** zeigt einen Zustand, bei dem im Sichtfeld (linkes Bild) einer Positionsoptik (nicht eingezeichnet) eine Positionsmarke 4 sichtbar ist. Zu einem beliebigen Zeitpunkt war im Sichtfeld (rechtes Bild) einer Ausrichtungsoptik (nicht eingezeichnet) eine Ausrichtungsmarke 5 messbar.

Die **Figur 8b** zeigt einen Zustand, bei dem im Sichtfeld (linkes Bild) einer Positionsoptik (nicht eingezeichnet) eine Positionsmarke 4 sichtbar ist, die durch eine Relativverschiebung eines Substrathalters (nicht eingezeichnet) solange verschoben wurde, bis sich die Ausrichtungsmarke 5 in einer gewünschten Position befindet. Der Anschaulichkeit halber wurde die gewünschte Position für die Ausrichtungsmarke 5 so gewählt, dass sie auf der optischen Achse der Ausrichtungsoptik (nicht eingezeichnet) liegt. Die Vermessung der Positionsmarke 4 kann pixelgenau erfolgen und wird damit zur Feinpositionierung verwendet.

### Bezugszeichenliste

- 1o, lo', 1o", 1o‴, 1u: Substrathalter
- 2o, 2u: Substrat
- 3ol, 3or, 3ol', 3or', 3o", 3ov, 3oh: Positionsmarkenfeld
- 4, 4o, 4ol, 4or, 4oh, 4ov: Positionsmarke
- 5, 5ol, 5or, 5ul, 5ur: Ausrichtungsmarke
- 6ol, 6or, 6ul, 6ur: Ausrichtungsoptik
- 7ul, 7ur, 7uv, 7uh: Positionsoptik
- 8, 8o, 8u: Fixierelemente
- 9: Öffnungen
- 10: Verformungselement

## Patentansprüche

1. Vorrichtung zum Ausrichten von Substraten (2o, 2u), umfassend:
- einen ersten Substrathalter (1o, 1o', 1o", 1o‴, 1u) zur Aufnahme eines ersten Substrates (2o, 2u), wobei das erste Substrat (2o, 2u) mindestens zwei Ausrichtungsmarken (5, 5ol, 5or, 5ul, 5ur) aufweist,
- einen zweiten Substrathalter (1o, 1o', 1o", 1o‴, 1u) zur Aufnahme eines zweiten Substrates (2o, 2u), wobei das zweite Substrat (2o, 2u) mindestens zwei weitere Ausrichtungsmarken (5, 5ol, 5or, 5ul, 5ur) aufweist,
- mindestens eine Ausrichtungsoptik (6ol, 6or, 6ul, 6ur) zur Erfassung der Ausrichtungsmarken (5, 5ol, 5or, 5ul, 5ur),
**dadurch gekennzeichnet, dass**
- die Vorrichtung weiterhin aufweist:
- mindestens eine Positionsoptik (7ul, 7ur, 7uv, 7uh) zur Erfassung von Positionsmarken (4, 4o, 4ol, 4or, 4oh, 4ov),
wobei die Ausrichtungsmarken (5, 5ol, 5or, 5ul, 5ur) des ersten Substrates (2o, 2u) und die weiteren Ausrichtungsmarken (5, 5ol, 5or, 5ul, 5ur) des zweiten Substrates (2o, 2u) in Abhängigkeit der Positionsmarken (4, 4o, 4ol, 4or, 4oh, 4ov) zueinander ausgerichtet werden.

2. Vorrichtung nach Anspruch 1, wobei die Ausrichtungsmarken (5, 5ol, 5or, 5ul, 5ur) der Substrate (2o, 2u) über die Positionsmarken (4, 4o, 4ol, 4or, 4oh, 4ov) zueinander ausrichtbar sind, wenn eine oder mehrere der mindestens zwei Ausrichtungsmarken (5, 5ol, 5or, 5ul, 5ur) des ersten Substrates (2o, 2u) durch das zweite Substrat (2o, 2u) für die mindestens eine Ausrichtungsoptik (6ol, 6or, 6ul, 6ur) verdeckt wird und/oder wenn eine oder mehrere der mindestens zwei weiteren Ausrichtungsmarken (5, Sol, 5or, 5ul, 5ur) des zweiten Substrates (2o, 2u) durch das erste Substrat (2o, 2u) für die mindestens eine Ausrichtungsoptik (6ol, 6or, 6ul, 6ur) verdeckt wird.

3. Vorrichtung nach wenigstens einem der vorhergehenden Ansprüche, wobei ein Positionsmarkenfeld (3ol, 3or, 3ol', 3or', 3o", 3ov, 3oh) durch die, insbesondere regelmäßig angeordneten, Positionsmarken (4, 4o, 4ol, 4or, 4oh, 4ov) ausgebildet ist, wobei insbesondere die Lage von unterschiedlichen Positionsmarken (4, 4o, 4ol, 4or, 4oh, 4ov), insbesondere in dem durch die Positionsmarken (4, 4o, 4ol, 4or, 4oh, 4ov) ausgebildeten Positionsmarkenfeld (3ol, 3or, 3ol', 3or', 3o'', 3ov, 3oh), zueinander bekannt ist.

4. Vorrichtung nach wenigstens einem der vorhergehenden Ansprüche, wobei die Positionsmarken (4, 4o, 4ol, 4or, 4oh, 4ov) durch eine Vielzahl von, insbesondere unregelmäßig angeordneten, Feinpositionierungselementen ausgebildet sind.

5. Vorrichtung nach wenigstens einem der vorhergehenden Ansprüche, wobei jede Positionsmarke (4, 4o, 4ol, 4or, 4oh, 4ov) unterschiedlich ausgebildet ist, wobei insbesondere die Positionsmarken einen bestimmten, insbesondere durch die Positionsoptik (7ul, 7ur, 7uv, 7uh) erfassbaren, Informationsgehalt aufweist.

6. Vorrichtung nach wenigstens einem der vorhergehenden Ansprüche, wobei die Positionsmarken (4, 4o, 4ol, 4or, 4oh, 4ov) eine oder mehrere der folgenden Ausprägungen aufweist:
- QR Code
- Strichcode
- Geometrische, insbesondere dreidimensionale, Figur,
- Zeichenfolge, insbesondere Buchstabenfolge und/oder Zahlenfolge, vorzugsweise Binärcode,
- Bild.

7. Vorrichtung nach wenigstens einem der vorhergehenden Ansprüche, wobei mindestens ein Substrathalter (1o, 1o', 1o'', 1o‴, 1u) und/oder die mindestens eine Positionsoptik (7ul, 7ur, 7uv, 7uh) in mindestens zwei Richtungen, insbesondere in x-Richtung und y-Richtung, bewegbar ist.

8. Vorrichtung nach wenigstens einem der vorhergehenden Ansprüche, wobei die Positionsmarken (4, 4o, 4ol, 4or, 4oh, 4ov) seitlich neben mindestens einem der Substrate (2o, 2u) angeordnet sind, wodurch insbesondere die Ausrichtungsmarken (5, 5ol, 5or, 5ul, 5ur) der Substrate (2o, 2u) zueinander ausrichtbar sind, wenn die Ausrichtungsmarken (5, 5ol, 5or, 5ul, 5ur) des einen Substrates (2o, 2u) durch das andere Substrat (2o, 2u) für die mindestens eine Ausrichtungsoptik (6ol, 6or, 6ul, 6ur) verdeckt sind.

9. Vorrichtung nach wenigstens einem der vorhergehenden Ansprüche, wobei die Positionsmarken (4, 4o, 4ol, 4or, 4oh, 4ov) auf mindestens einem der Substrathalter (1o, 1o', 1o'', 1o‴, 1u) angeordnet sind.

10. Vorrichtung nach wenigstens einem der vorhergehenden Ansprüche, wobei die Positionsmarken (4, 4o, 4ol, 4or, 4oh, 4ov) auf mindestens einer Substrathalteroberfläche angeordnet sind.

11. Vorrichtung nach wenigstens einem der vorhergehenden Ansprüche, wobei die Positionsmarken (4, 4o, 4ol, 4or, 4oh, 4ov) auf der gleichen Höhe mit einer Substratoberfläche mindestens eines der Substrate (2o, 2u) angeordnet sind.

12. Vorrichtung nach wenigstens einem der vorhergehenden Ansprüche, wobei die Positionen der Ausrichtungsmarken (5, 5ol, 5or, 5ul, 5ur) der Substrate (2o, 2u), insbesondere kontinuierlich, durch die mindestens eine Positionsoptik (7ul, 7ur, 7uv, 7uh ) bei dem Ausrichten der Ausrichtungsmarken (5, 5ol, 5or, 5ul, 5ur) der Substrate (2o, 2u) zueinander erfassbar ist.

13. Verfahren zum Ausrichten von zwei Substraten (2o, 2u) mit einer Vorrichtung nach wenigstens einem der vorhergehenden Ansprüche mit zumindest den folgenden Schritten, insbesondere mit dem folgenden Ablauf:
i) Fixieren zweier Substrate (2o, 2u) auf jeweils einem Substrathalter (1o, 1o', 1o", 1o‴, 1u),
ii) Erfassen von Ausrichtungsmarken (5, 5ol, 5or, 5ul, 5ur) auf den Substraten (2o, 2u),
iii) Erfassen von Positionsmarken (4, 4o, 4ol, 4or, 4oh, 4ov),
iv) Ausrichten der Ausrichtungsmarken (5, 5ol, 5or, 5ul, 5ur) der Substrate (2o, 2u) zueinander in Abhängigkeit der Positionsmarken (4, 4o, 4ol, 4or, 4oh, 4ov).

14. Verfahren zum Ausrichten von zwei Substraten (2o, 2u), wobei nach Schritt iii) die Position der Ausrichtungsmarken (5, 5ol, 5or, 5ul, 5ur) und/oder deren Lage zueinander, bestimmbar ist.

## Claims

1. A device for aligning substrates (2o, 2u), comprising:
- a first substrate holder (1o, 1o', 1o'', 1o‴, 1u) for mounting a first substrate (2o, 2u), wherein the first substrate (2o, 2u) comprises at least two alignment marks (5, 5ol, 5or, 5ul, Sur),
- a second substrate holder (1o, 1o', 1o'', 1o‴, 1u) for mounting a second substrate (2o, 2u), wherein the second substrate (2o, 2u) comprises at least two further alignment marks (5, 5ol, 5or, 5ul, Sur),
- at one least alignment lens system (6ol, 6or, 6ul, 6ur) for the detection of alignment marks (5, 5ol, 5or, 5ul, 5ur),
**characterised in that**
- the device further comprises:
- at least one position lens system (7ul, 7ur, 7uv, 7uh) for the detection of position marks (4, 4o, 4ol, 4or, 4oh, 4ov),
wherein the alignment marks (5, 5ol, 5or, 4ul, 4ur) of the first substrate (2o, 2u) and the further alignment marks (5, 5ol, 5or, 5ul, 5ur) of the second substrate (2o, 2u) are aligned with one another depending on the position marks (4, 4o, 4ol, 4or, 4oh, 4ov).

2. The device according to claim **1,** wherein the alignment marks (5, 5ol, 5or, 5ul, 5ur) of the substrates (2o, 2u) can be aligned with one another via the position marks (4, 4o, 4ol, 4or, 4oh, 4ov), when one or more of the at least two alignment marks (5, 5ol, 5or, 5ul, 5ur) of the first substrate (2o, 2u) are covered by the second substrate (2o, 2u) for the at least one alignment lens system (6ol, 6or, 6ul, 6ur) and/or when one or more of the at least two further alignment marks (5, 5ol, 5or, 5ul, 5ur) of the second substrate (2o, 2u) are covered by the first substrate (2o, 2u) for the at least one alignment lens system (6ol, 6or, 6ul, 6ur).

3. The device according to at least one of the preceding claims, wherein a position mark field (3ol, 3or, 3ol', 3or', 3o", 3ov, 3oh) is formed by the, in particular, regularly arranged position marks (4, 4o, 4ol, 4or, 4oh, 4ov), wherein in particular the location of different position marks (4, 4o, 4ol, 4or, 4oh, 4ov), in particular in the position mark field (3ol, 3or, 3ol', 3or', 3o", 3ov, 3oh) formed by the position marks (4, 4o, 4ol, 4or, 4oh, 4ov), with respect to one another is known.

4. The device according to at least one of the preceding claims, wherein the position marks (4, 4o, 4ol, 4or, 4oh, 4ov) are formed by a multiplicity of, in particular irregularly arranged, fine positioning elements.

5. The device according to at least one of the preceding claims, wherein each position mark (4, 4o, 4ol, 4or, 4oh, 4ov) is formed differently, wherein in particular the position marks have a specific information content, in particular detectable by the position lens system (7ul, 7ur, 7uv, 7uh).

6. The device according to at least one of the preceding claims, wherein the position marks (4, 4o, 4ol, 4or, 4oh, 4ov) have one or more of the following characteristics:
- QR code
- barcode
- geometrical, in particular three-dimensional, figure,
- character sequence, in particular letter sequence and/or number sequence, preferably a binary code,
- image.

7. The device according to at least one of the preceding claims, wherein at least one substrate holder (1o, 1o', 1o'', 1o‴, 1u) and/or the at least one position lens system (7ul, 7ur, 7uv, 7uh) can be moved in at least two directions, in particular in the x-direction and y-direction.

8. The device according to at least one of the preceding claims, wherein the position marks (4, 4o, 4ol, 4or, 4oh, 4ov) are arranged laterally beside at least one of the substrates (2o, 2u), as a result of which the alignment marks (5, 5ol, 5or, 5ul, 5ur) of the substrates (2o, 2u) can in particular be aligned with one another, when the alignment marks (5, 5ol, 5or, 5ul, 5ur) of the one substrate (2o, 2u) are covered by the other substrate (2o, 2u) for the at least one alignment lens system (6ol, 6or, 6ul, 6ur).

9. The device according to at least one of the preceding claims, wherein the position marks (4, 4o, 4ol, 4or, 4oh, 4ov) are arranged on at least one of the substrate holders (1o, 1o', 1o'', 1o‴, 1u).

10. The device according to at least one of the preceding claims, wherein the position marks (4, 4o, 4ol, 4or, 4oh, 4ov) are arranged on at least one substrate holder surface.

11. The device according to at least one of the preceding claims, wherein the position marks (4, 4o, 4ol, 4or, 4oh, 4ov) are arranged on the same level as a substrate surface of at least one of the substrates (2o, 2u).

12. The device according to at least one of the preceding claims, wherein the positions of the alignment marks (5, 5ol, 5or, 5ul, 5ur) of the substrates (2o, 2u) can be detected, in particular continuously, by the at least one position lens system (7ul, 7ur, 7uv, 7uh) in the alignment of the alignment marks (5, 5ol, 5or, 5ul, 4ur) of the substrates (2o, 2u) with one another.

13. A method for the alignment of two substrates (2o, 2u) using a device according to at least one of the preceding claims with at least the following steps, in particular with the following sequence:
i) fixing of two substrates (2o, 2u) each on a substrate holder (1o, 1o', 1o", 1o‴, 1u),
ii) detection of alignment marks (5, 5ol, 5or, 5ul, 5ur) on the substrates (2o, 2u),
iii) detection of position marks (4, 4o, 4ol, 4or, 4oh, 4ov),
iv) alignment of the alignment marks (5, 5ol, 5or, 5ul, 5ur) of the substrates (2o, 2u) with one another depending on the position marks (4, 4o, 4ol, 4or, 4oh, 4ov).

14. The method for the alignment of two substrates (2o, 2u), wherein after step iii) the position of alignment marks (5, 5ol, 5or, 5ul, 5ur) and/or their location with respect to one another can be determined.

## Revendications

1. Dispositif d'alignement de substrats (2o, 2u), comprenant :
- un premier porte-substrats (1o, 1o', 1o'', 1o‴, 1u) pour recevoir un premier substrat (2o, 2u), dans lequel le premier substrat (2o, 2u) présente au moins deux repères d'alignement (5, 5ol, 5or, 5ul, 5ur),
- un second porte-substrats (1o, 1o', 1o'', 1o‴, 1u) pour recevoir un second substrat (2o, 2u), dans lequel le second substrat (2o, 2u) présente au moins deux repères d'alignement (5, 5ol, 5or, 5ul, 5ur) supplémentaires,
- au moins une optique d'alignement (6ol, 6or, 6ul, 6ur) pour détecter les repères d'alignement (5, 5ol, 5or, 5ul, 5ur),
**caractérisé en ce que**
- le dispositif présente en outre :
- au moins une optique de position (7ul, 7ur, 7uv, 7uh) pour détecter des repères de position (4, 4o, 4ol, 4or, 4oh, 4ov),
dans lequel les repères d'alignement (5, 5ol, 5or, 5ul, 5ur) du premier substrat (2o, 2u) et les repères d'alignement (5, 5ol, 5or, 5ul, 5ur) supplémentaires du second substrat (2o, 2u) sont alignés l'un par rapport à l'autre en fonction des repères de position (4, 4o, 4ol, 4or, 4oh, 4ov).

2. Dispositif selon la revendication 1, dans lequel les repères d'alignement (5, 5ol, 5or, 5ul, 5ur) des substrats (2o, 2u) peuvent être alignés l'un par rapport à l'autre sur les repères de position (4, 4o, 4ol, 4or, 4oh, 4ov) lorsqu'un ou plusieurs des au moins deux repères d'alignement (5, 5ol, 5or, 5ul, 5ur) du premier substrat (2o, 2u) sont recouverts par le second substrat (2o, 2u) pour l'au moins une optique d'alignement (6ol, 6or, 6ul, 6ur) et/ou lorsqu'un ou plusieurs des au moins deux repères d'alignement (5, 5ol, 5or, 5ul, 5ur) supplémentaires du second substrat (2o, 2u) sont recouverts par le premier substrat (2o, 2u) pour l'au moins une optique d'alignement (6ol, 6or, 6ul, 6ur).

3. Dispositif selon au moins l'une des revendications précédentes, dans lequel un champ de repère de position (3ol, 3or, 3ol', 3or', 3o", 3ov, 3oh) est formé par les repères de position (4, 4o, 4ol, 4or, 4oh, 4ov) disposés en particulier uniformément, dans lequel en particulier, la position de différents repères de position (4, 4o, 4ol, 4or, 4oh, 4ov), en particulier dans le champ de repère de position (3ol, 3or, 3ol', 3or', 3o", 3ov, 3oh) est formé par les repères de position (4, 4o, 4ol, 4or, 4oh, 4ov) entre eux entre eux est connue.

4. Dispositif selon au moins l'une des revendications précédentes, dans lequel les repères de position (4, 4o, 4ol, 4or, 4oh, 4ov) sont formés par une pluralité d'éléments de positionnement fin disposés en particulier non uniformément.

5. Dispositif selon au moins l'une des revendications précédentes, dans lequel chaque repère de position (4, 4o, 4ol, 4or, 4oh, 4ov) est formé de manière différente, dans lequel en particulier les repères de position indiquent un
contenu d'information déterminé, pouvant être détecté en particulier par l'optique de position (7ul, 7ur, 7uv, 7uh).

6. Dispositif selon au moins l'une des revendications précédentes, dans lequel les repères de position (4, 4o, 4ol, 4or, 4oh, 4ov) présentent un ou plusieurs des marquages suivants :
- code QR,
- code-barres,
- figure géométrique, en particulier en trois dimensions,
- suite de signes, en particulier suite de lettres et/ou suite de chiffres, de préférence code binaire,
- image.

7. Dispositif selon au moins l'une des revendications précédentes, dans lequel au moins un porte-substrats (1o, 1o', 1o'', 1o‴, 1u) et/ou l'au moins une optique de position (7ul, 7ur, 7uv, 7uh) est mobile dans au moins deux directions, en particulier dans la direction x et la direction y.

8. Dispositif selon au moins l'une des revendications précédentes, dans lequel les repères de position (4, 4o, 4ol, 4or, 4oh, 4ov) sont disposés latéralement à côté d'au moins un des substrats (2o, 2u), ce par quoi en particulier les repères d'alignement (5, 5ol, 5or, 5ul, 5ur) des substrats (2o, 2u) peuvent être alignés l'un par rapport à l'autre, lorsque les repères d'alignement (5, 5ol, 5or, 5ul, 5ur) de l'un substrat (2o, 2u) sont recouverts par l'autre substrat (2o, 2u) pour l'au moins une optique d'alignement (6ol, 6or, 6ul, 6ur).

9. Dispositif selon au moins l'une des revendications précédentes, dans lequel les repères de position (4, 4o, 4ol, 4or, 4oh, 4ov) sont disposés sur au moins un des porte-substrats (1o, 1o', 1o'', 1o‴, 1u).

10. Dispositif selon au moins l'une des revendications précédentes, dans lequel les repères de position (4, 4o, 4ol, 4or, 4oh, 4ov) sont disposés sur au moins une surface du porte-substrats.

11. Dispositif selon au moins l'une des revendications précédentes, dans lequel les repères de position (4, 4o, 4ol, 4or, 4oh, 4ov) sont disposés à la même hauteur qu'une surface de substrat d'au moins un des substrats (2o, 2u).

12. Dispositif selon au moins l'une des revendications précédentes, dans lequel les positions des repères d'alignement (5, 5ol, 5or, 5ul, 5ur) des substrats (2o, 2u) l'une par rapport à l'autre peuvent être détectées, en particulier de manière continue, par l'au moins une optique de position (7ul, 7ur, 7uv, 7uh) lors de l'alignement des repères d'alignement (5, 5ol, 5or, 5ul, 5ur) des substrats (2o, 2u).

13. Procédé d'alignement de deux substrats (2o, 2u) comprenant un dispositif selon au moins l'une des revendications précédentes comprenant au moins les étapes suivantes, en particulier le déroulement suivant :
i) fixation de deux substrats (2o, 2u) sur respectivement un porte-substrats (1o, 1o', 1o'', 1o‴, 1u),
ii) détection de repères d'alignement (5, 5ol, 5or, 5ul, 5ur) sur les substrats (2o, 2u),
iii) détection de repères de position (4, 4o, 4ol, 4or, 4oh, 4ov),
iv) alignement des repères d'alignement (5, 5ol, 5or, 5ul, 5ur) des substrats (2o, 2u) l'un par rapport à l'autre en fonction des repères de position (4, 4o, 4ol, 4or, 4oh, 4ov).

14. Procédé d'alignement de deux substrats (2o, 2u), dans lequel après l'étape iii), la position des repères d'alignement (5, 5ol, 5or, 5Sul, 5ur) et/ou leur position l'un par rapport à l'autre, peut être définie.
